# EUROPEAN PATENT APPLICATION

(11) **EP 4 672 938 A1**
(43) Date of publication of application: **31.12.2025**
(21) Application number: 25183018.8
(22) Date of filing: 16.06.2025
(51) Int. Cl.: H10K 59/126, H10K 59/131, H10K 59/65, H10K 59/40

(54) **DISPLAY DEVICE AND ELECTRONIC DEVICE**

(30) Priority: 26.06.2024 KR 20240083450
(71) Applicant: Samsung Display Co., Ltd., Yongin-si, Gyeonggi-do 17113 (KR)
(72) Inventor: JUNG, Haegoo, Giheung-Gu, Yongin-si, Gyeonggi-Do (KR); JUNG, Yeon-Shil, Giheung-Gu, Yongin-si, Gyeonggi-Do (KR)
(74) Representative: Dr. Weitzel & Partner

(57) **Abstract**

A display device includes a base substrate (BS) including a hole area (HA), an active area (AA) adjacent to the hole area , and a peripheral area (NAA) adjacent to the active area, a first crack sensing pattern (HCP1) disposed on the hole area, a first connecting line (HCL1) connected to an end of the first crack sensing pattern and disposed on the peripheral area, a second crack sensing pattern (HCP2) disposed on the hole area and disposed at a layer different from a layer at which the first crack sensing pattern is disposed, and a second connecting line (HCL2) connected to an end of the second crack sensing pattern and disposed on the peripheral area. The first crack sensing pattern and the first connecting line are disposed at a same layer as each other, and the second crack sensing pattern and the second connecting line are disposed at a same layer as each other.

## Description

### BACKGROUND

### (1) Field

Embodiments of the invention described herein relate to a display device, and more particularly, relate to a display device including a crack sensing pattern.

### (2) Description of the Related Art

A display device may be activated depending on an electrical signal. The display device may include various electronic parts such as a display panel, an electronic module, and the like. The display panel may include a display unit that displays an image or a sensing unit that senses an external input. The electronic parts may be electrically connected with one another by signal lines arranged in various ways.

The display unit may include a light emitting element that generates an image. The sensing unit may include sensing electrodes for sensing an external input. The sensing electrodes may be disposed in an active area. The sensing unit may be designed to provide uniform sensitivity for the entire active area.

### SUMMARY

The invention is defined by independent claim 1. Embodiments of the invention provide a display device with improved reliability.

In an embodiment, the shielding electrode may be disposed between the transistor and the base substrate on a cross-section, and the first crack sensing pattern may be disposed at a same layer as the shielding electrode.

In an embodiment, the display device may include a sensing unit disposed over the plurality of pixels, where the sensing unit may include a plurality of conductive patterns and a plurality of sensing insulation layers which covers the plurality of conductive patterns, and the second crack sensing pattern may be disposed at a same layer as at least one selected from the plurality of conductive patterns.

In an embodiment, the crack sensing pattern and the connecting line may be disposed at a same layer as the shielding electrode, and the bridge line may be disposed at a layer different from a layer at which the crack sensing pattern is disposed.

In an embodiment, the display device may include a plurality of insulating layers which covers a pixel circuit including the transistor and an input electrode and an output electrode disposed on one insulating layer among the plurality of insulating layers and connected with a semiconductor pattern by a through-hole defined through at least one selected from the plurality of insulating layers. In such an embodiment, the pixel circuit may further include the semiconductor pattern and an upper electrode disposed over the semiconductor pattern to overlap the semiconductor pattern, and the bridge line may be disposed at a same layer as one of the upper electrode, the input electrode, and the output electrode.

In an embodiment, the first crack sensing pattern may be disposed at a same layer as the shielding electrode.

In an embodiment, the display device may include a sensing unit disposed over the plurality of pixels, where the sensing unit may include a plurality of conductive patterns and a plurality of sensing insulation layers which covers the plurality of conductive patterns, and the first connecting line and the second connecting line may be disposed at a same layer as at least one selected from the plurality of conductive patterns.

In an embodiment, the display device may include a plurality of insulating layers which covers the transistor, and the first crack sensing pattern may be connected with the first connecting line and the second connecting line by a contact hole defined through at least one selected from the plurality of insulating layers and the plurality of sensing insulation layers.

In an embodiment, the base substrate may further include a cover area that covers the active area when viewed from above a plane, and the contact hole may not overlap the cover area and may overlap the peripheral area when viewed from above the plane.

In an embodiment, the display device may include a connecting electrode disposed on the plurality of insulating layers and connected with the first crack sensing pattern by a first contact hole defined through the plurality of insulating layers, and the first connecting line and the second connecting line may be connected with the first crack sensing pattern by a second contact hole defined through at least one selected from the plurality of sensing insulation layers.

In an embodiment, the first connecting line and the second connecting line may be disposed at a same layer as the first crack sensing pattern.

In an embodiment, the display device may include a second crack sensing pattern disposed on the base substrate to overlap the hole area, a third connecting line connected to one end of the second crack sensing pattern and disposed on the base substrate to overlap the peripheral area, and a fourth connecting line connected to an opposite end of the second crack sensing pattern and disposed on the base substrate to overlap the peripheral area. In such an embodiment, the second crack sensing pattern, the third connecting line, and the fourth connecting line may be disposed at a same layer as each other, and the second crack sensing pattern may be disposed at a layer different from a layer at which the first crack sensing pattern is disposed.

In an embodiment, the display device may include a sensing unit disposed over the plurality of pixels, where the sensing unit may include a plurality of conductive patterns and a plurality of sensing insulation layers which covers the plurality of conductive patterns, and the second crack sensing pattern may be disposed at a same layer as at least one selected form the plurality of conductive patterns.

In an embodiment, the display device may include a first bridge line disposed between the first crack sensing pattern and the first connecting line and connected to the first crack sensing pattern and the first connecting line and a second bridge line disposed between the first crack sensing pattern and the second connecting line and connected to the first crack sensing pattern and the second connecting line.

In an embodiment, the first connecting line and the second connecting line may be disposed at a same layer as the first crack sensing pattern.

In an embodiment, the display device may include a plurality of insulating layers which covers a pixel circuit including the transistor. In an embodiment, the pixel circuit may further include a semiconductor pattern and an upper electrode disposed over the semiconductor pattern to overlap the semiconductor pattern, and the first bridge line and the second bridge line may be disposed at a same layer as the upper electrode.

In an embodiment, the display device may include an input electrode and an output electrode disposed on one insulating layer among the plurality of insulating layers and connected with the semiconductor pattern by a through-hole defined through at least one selected from the plurality of insulating layers, and the first bridge line and the second bridge line may be disposed at a same layer as the input electrode and the output electrode.

In an embodiment, the display device may include a plurality of insulating layers which covers the transistor, and the first bridge line and the second bridge line may be connected with the first crack sensing pattern by a third contact hole defined through at least one selected from the plurality of insulating layers and may be connected with the first connecting line and the second connecting line by a fourth contact hole defined through at least one selected from the plurality of insulating layers.

In an embodiment, the third contact hole may overlap the hole area, and the fourth contact hole may overlap the peripheral area.

### BRIEF DESCRIPTION OF THE DRAWINGS

The above and other features of embodiments of the invention will become apparent by describing in detail embodiments thereof with reference to the accompanying drawings.
FIG. 1A is an assembled perspective view of a display device according to an embodiment of the invention.
FIG. 1B is an exploded perspective view of the display device illustrated in FIG. 1A.
FIG. 2 is a block diagram of the display device illustrated in FIG. 1A.
FIG. 3A is a plan view of a display unit according to an embodiment of the invention.
FIG. 3B is an enlarged view of a partial area illustrated in FIG. 3A.
FIG. 3C is a plan view of a sensing unit according to an embodiment of the invention.
FIG. 4 is a sectional view of a partial area of a display panel according to an embodiment of the invention.
FIG. 5A is a plan view illustrating a portion of the display panel according to an embodiment of the invention.
FIG. 5B is a schematic plan view illustrating a crack sensing circuit according to an embodiment of the invention.
FIG. 6 is a sectional view taken along line A-A' in FIG. 5B.
FIG. 7 is a plan view of the sensing unit according to an embodiment of the invention.
FIG. 8 is a schematic plan view illustrating a crack sensing circuit according to an embodiment of the invention.
FIG. 9 is a sectional view taken along line B-B' in FIG. 8.
FIG. 10 is a plan view of the sensing unit according to an embodiment of the invention.
FIG. 11 is a schematic plan view illustrating a crack sensing circuit according to an embodiment of the invention.
FIG. 12 is a sectional view taken along line C-C' in FIG. 11 according to an embodiment of the invention.
FIG. 13 is a sectional view taken along line C-C' in FIG. 11 according to an embodiment of the invention.

### DETAILED DESCRIPTION

The invention now will be described more fully hereinafter with reference to the accompanying drawings, in which various embodiments are shown. This invention may, however, be embodied in many different forms, and should not be construed as limited to the embodiments set forth herein. Rather, these embodiments are provided so that this invention will be thorough and complete, and will fully convey the scope of the invention to those skilled in the art.

It will be understood that when an element is referred to as being "on" another element, it can be directly on the other element or intervening elements may be present therebetween. In contrast, when an element is referred to as being "directly on" another element, there are no intervening elements present.

In this specification, when a component (or an area, a layer, a part, etc.) is referred to as being ", "connected to" or "coupled to" another component, this means that the component may be directly connected to, or coupled to the other component or a third component may be present therebetween.

Identical reference numerals refer to identical components. Additionally, in the drawings, the thicknesses, proportions, and dimensions of components are exaggerated for effective description.

It will be understood that, although the terms "first," "second," "third" etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, "a first element," "component," "region," "layer" or "section" discussed below could be termed a second element, component, region, layer or section without departing from the teachings herein.

Furthermore, relative terms, such as "lower" or "bottom" and "upper" or "top," may be used herein to describe one element's relationship to another element as illustrated in the Figures. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The term "lower," can therefore, encompasses both an orientation of "lower" and "upper," depending on the particular orientation of the figure. Similarly, if the device in one of the figures is turned over, elements described as "below" or "beneath" other elements would then be oriented "above" the other elements. The terms "below" or "beneath" can, therefore, encompass both an orientation of above and below.

The terminology used herein is for the purpose of describing particular embodiments only and is not intended to be limiting. As used herein, "a", "an," "the," and "at least one" do not denote a limitation of quantity, and are intended to include both the singular and plural, unless the context clearly indicates otherwise. Thus, reference to "an" element in a claim followed by reference to "the" element is inclusive of one element and a plurality of the elements. For example, "an element" has the same meaning as "at least one element," unless the context clearly indicates otherwise. "At least one" is not to be construed as limiting "a" or "an." "Or" means "and/or." As used herein, the term "and/or" includes any and all combinations of one or more of the associated listed items. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and the present invention, and will not be interpreted in an idealized or overly formal sense unless expressly so defined herein.

Embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

Hereinafter, embodiments of the invention will be described with reference to the accompanying drawings.

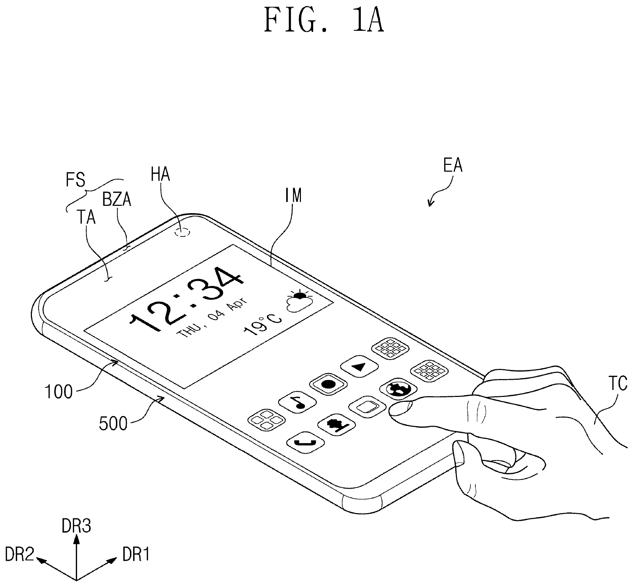

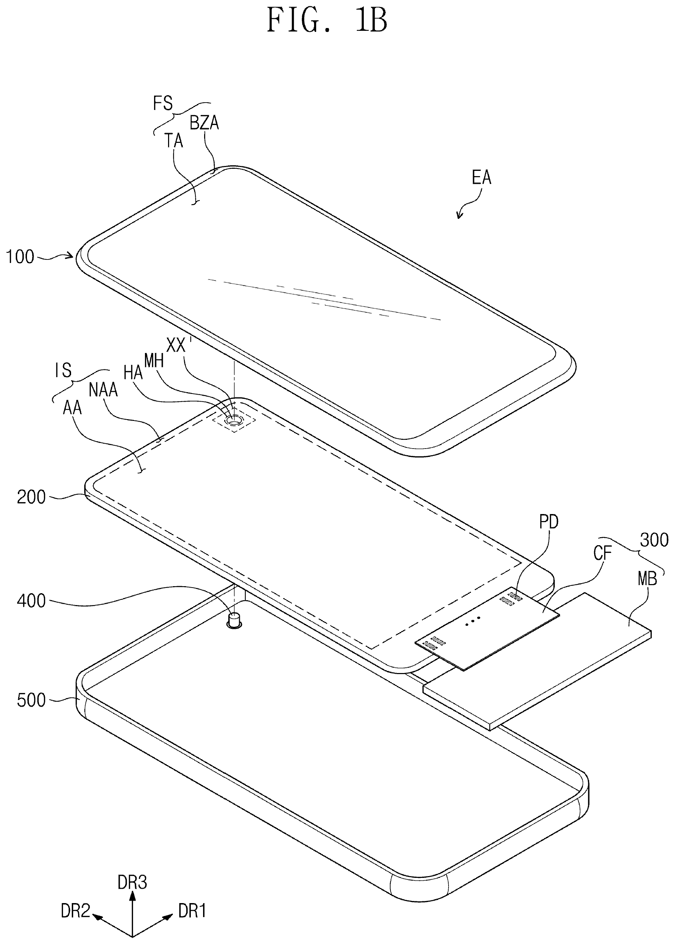

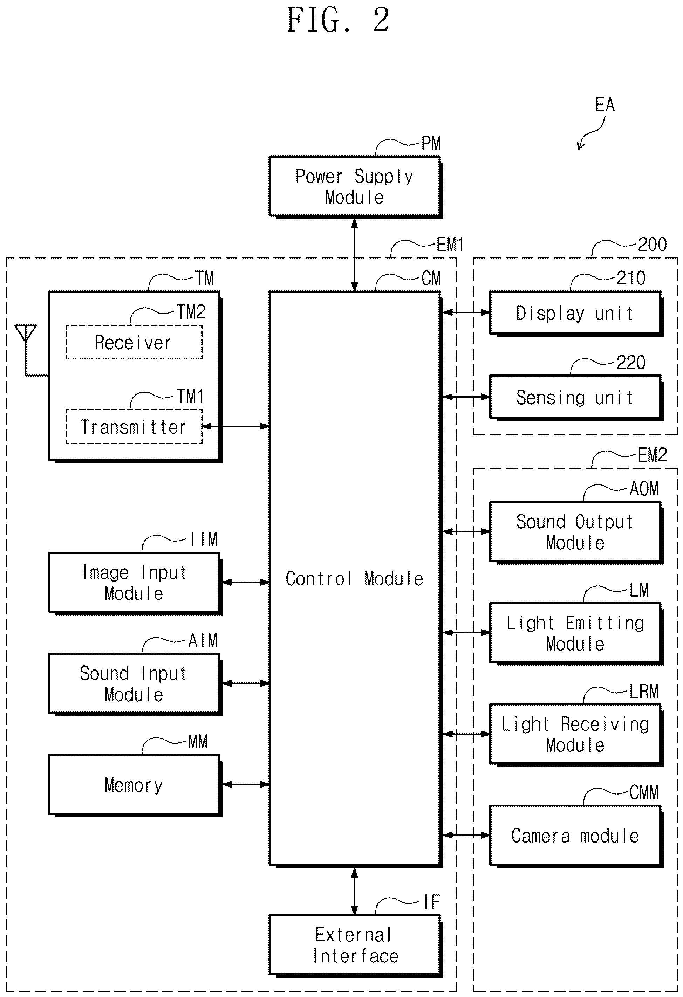

FIG. 1A is an assembled perspective view of a display device according to an embodiment of the invention. The display device may be called electronic device. FIG. 1B is an exploded perspective view of the display device illustrated in FIG. 1A. FIG. 2 is a block diagram of the display device illustrated in FIG. 1A. Hereinafter, embodiments of a display device according to the invention will be described with reference to FIGS. 1A to 2.

An embodiment of the display device EA may be activated depending on an electrical signal. The display device EA may include various embodiments. In an embodiment, for example, the display device EA may include a tablet computer, a notebook computer, a computer, a smart television, or the like. In an embodiment, as shown in FIGS. 1A to 2, the display device EA may be a smart phone. The display device EA may be referred to as an electronic device.

In an embodiment, as illustrated in FIG. 1A, the display device EA may display an image IM on a front surface FS. The front surface FS may be defined parallel to a plane defined by a first direction DR1 and a second direction DR2. The front surface FS includes a transmissive area TA and a bezel area BZA adjacent to the transmissive area TA.

The display device EA displays the image IM in the transmissive area TA. The image IM may include at least one of a static image and a dynamic image. In FIG. 1A, a clock and a plurality of icons are illustrated as an example of the image IM.

The transmissive area TA may have a quadrangular shape parallel to the first direction DR1 and the second direction DR2. However, this is illustrative, and the transmissive area TA may have various shapes and is not limited to any one embodiment.

The bezel area BZA is adjacent to the transmissive area TA. The bezel area BZA may surround the transmissive area TA. However, this is illustrative, and the bezel area BZA may be disposed adjacent to only one side of the transmissive area TA, or may be omitted. The display device EA according to an embodiment of the invention may include various embodiments and is not limited to any one embodiment.

The normal direction of the front surface FS may correspond to the thickness direction DR3 (hereinafter, referred to as the third direction) of the display device EA. In an embodiment, front surfaces (or upper surfaces) and rear surfaces (or lower surfaces) of members may be defined based on the direction in which the image IM is displayed. The front surfaces and the rear surfaces may be opposite to each other in the third direction DR3.

The directions indicated by the first to third directions DR1, DR2, and DR3 may be relative concepts and may be changed to other directions. Hereinafter, the first to third directions are directions indicated by the first to third directions DR1, DR2, and DR3, respectively, and refer to the same reference numerals as the first to third directions DR1, DR2, and DR3.

The display device EA according to an embodiment of the invention may sense an input TC of a user that is applied from the outside. The input TC of the user includes various types of external inputs such as an input applied by a part of the user's body, light, heat, pressure, or the like. In addition, the display device EA may sense an input proximate or adjacent to the display device EA as well as an input in contact with the display device EA.

In an embodiment, the input TC of the user may be a touch by the user's hand applied to the front surface FS as shown in FIG. 1A. However, this is illustrative, and the user's input TC may be provided in various forms as described above. In an embodiment, the display device EA may sense the user's input TC applied to the side surface or the rear surface of the display device EA depending on the structure of the display device EA and is not limited to any one embodiment.

In an embodiment, as shown in FIG. 1B, the display device EA may include a window 100, a display panel 200, a circuit board 300, an electronic module 400, and an outer case 500. The window 100 and the outer case 500 are coupled to define the exterior of the display device EA.

The window 100 is disposed on the display panel 200 and covers a front surface IS of the display panel 200. The window 100 may include an optically clear insulating material. In an embodiment, for example, the window 100 may include glass or plastic. The window 100 may have a multi-layer structure or a single-layer structure. In an embodiment, for example, the window 100 may have a stacked structure of a plurality of plastic films coupled through an adhesive, or may have a stacked structure of a glass substrate and a plastic film coupled through an adhesive.

The window 100 includes a front surface FS exposed to the outside. The front surface FS of the display device EA may be substantially defined by the front surface FS of the window 100.

In an embodiment, a transmissive area TA may be an optically clear area. The transmissive area TA may have a shape corresponding to an active area AA. In an embodiment, for example, the transmissive area TA overlaps all or at least part of the active area AA. The image IM displayed in the active area AA of the display panel 200 may be visible from the outside through the transmissive area TA.

A bezel area BZA may have a lower light transmittance than the transmissive area TA. The bezel area BZA defines the shape of the transmissive area TA. The bezel area BZA may be adjacent to the transmissive area TA and may surround the transmissive area TA.

The bezel area BZA may have a certain color. In an embodiment where the window 100 is implemented with a glass or plastic substrate, the bezel area BZA may be a color layer printed or deposited on one surface of the glass or plastic substrate. Alternatively, the bezel area BZA may be formed by coloring a corresponding area of the glass or plastic substrate.

The bezel area BZA may cover a peripheral area NAA of the display panel 200 to block the peripheral area NAA from being visible from the outside. This is illustrative, and in the window 100 according to an embodiment of the invention, the bezel area BZA may be omitted.

The display panel 200 may display the image IM and may sense the external input TC. The display panel 200 includes the front surface IS that includes the active area AA and the peripheral area NAA. The active area AA may be activated depending on an electrical signal.

In an embodiment, the active area AA may be an area where the image IM is displayed and the external input TC is sensed. The transmissive area TA overlaps at least the active area AA. In an embodiment, for example, the transmissive area TA overlaps all or at least part of the active area AA. Accordingly, the user may visually recognize the image IM through the transmissive area TA, or may provide the external input TC through the transmissive area TA. However, this is illustrative, and the area where the image IM is displayed and the area where the external input TC is sensed may be separated from each other in the active area AA and are not limited to any one embodiment.

The peripheral area NAA may be covered by the bezel area BZA. The peripheral area NAA may be adjacent to the active area AA. The peripheral area NAA may surround the active area AA. A drive circuit or drive wiring for driving the active area AA may be disposed in the peripheral area NAA.

Various types of signal lines, pads PD, or electronic elements that provide electrical signals to the active area AA may be disposed in the peripheral area NAA. The peripheral area NAA may be covered by the bezel area BZA and may not be visible from the outside.

In an embodiment, the display panel 200 may be assembled in a flat state in which the active area AA and the peripheral area NAA face toward the window 100. However, this is illustrative, and in another embodiment, a portion of the peripheral area NAA of the display panel 200 may be bent. In such an embodiment, a portion of the peripheral area NAA may face toward the rear surface of the display device EA, and the bezel area BZA on the front surface FS of the display device EA may be decreased. Alternatively, the display panel 200 may be assembled in a state in which a portion of the active area AA is also bent. Alternatively, the peripheral area NAA may be omitted in the display panel 200 according to an embodiment of the invention.

Referring to FIG. 2, in an embodiment, the display panel 200 may include a display unit 210 and a sensing unit 220. The display unit 210 may be a component that substantially generates the image IM. The image IM generated by the display unit 210 may be visible to the user through the transmissive area TA.

The sensing unit 220 senses the external input TC applied from the outside. In an embodiment, as described above, the sensing unit 220 may sense the external input TC provided to the window 100.

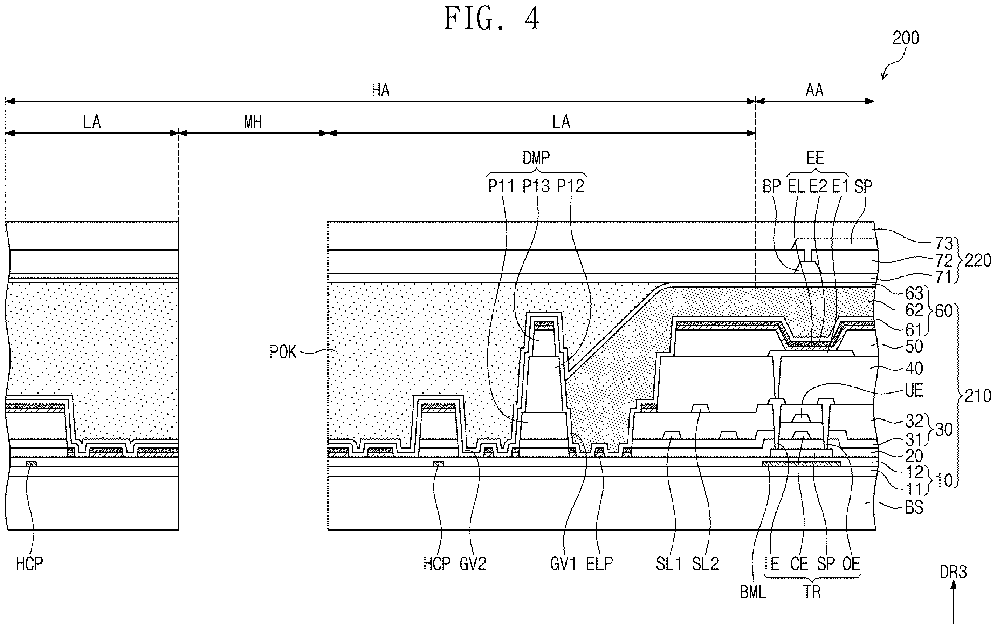

A hole area HA (or a first area) may be defined in the display panel 200. In an embodiment, the hole area HA may have a higher transmittance than the active area AA (or the second area). In an embodiment, a hole MH (refer to FIG. 4) in the hole area HA may be a through-hole and may have a high transmittance, and a wiring area LA (refer to FIG. 4) in the hole area HA may have a higher transmittance than the active area AA because a light emitting element EE (refer to FIG. 4) or a transistor TR (refer to FIG. 4) is not disposed in the wiring area LA. The hole area HA may be defined in a position overlapping the electronic module 400, which will be described below, when viewed from above the plane.

At least a portion of the hole area HA may be surrounded by the active area AA. In an embodiment, the hole area HA may be spaced apart from the peripheral area NAA (or the third area). In an embodiment, as shown in FIG. 1B, the hole area HA may be defined in the active area AA such that the entire periphery is surrounded by the active area AA.

The display panel 200 may include the hole MH that is defined in the hole area HA and that penetrates the display panel 200. The hole MH may penetrate (or be defined or formed through) at least one of the display unit 210 and the sensing unit 220. The periphery of the hole area HA may be substantially spaced apart from the periphery of the hole MH at a certain interval and may extend along the periphery of the hole MH. The periphery of the hole area HA may have a shape corresponding to the hole MH.

The circuit board 300 may be connected to the display panel 200. The circuit board 300 may include a flexible substrate CF and a main board MB. The flexible substrate CF may include an insulating film and conductive lines mounted on the insulating film. The conductive lines are connected to the pads PD and electrically connect the circuit board 300 and the display panel 200.

In an embodiment, the flexible substrate CF may be assembled in a bent state. Accordingly, the main board MB may be disposed on the rear surface of the display panel 200 and may be stably accommodated in the space provided by the outer case 500. In another embodiment, the flexible substrate CF may be omitted, and in this case, the main board MB may be directly connected to the display panel 200.

The main board MB may include signal lines and electronic elements that are not illustrated. The electronic elements may be connected to the signal lines and may be electrically connected with the display panel 200. The electronic elements generate various electrical signals, for example, a signal for generating the image IM or a signal for sensing the external input TC or process a sensed signal. A plurality of main boards MB may be provided to correspond to respective electrical signals to be generated and processed, and the invention is not limited to any one embodiment.

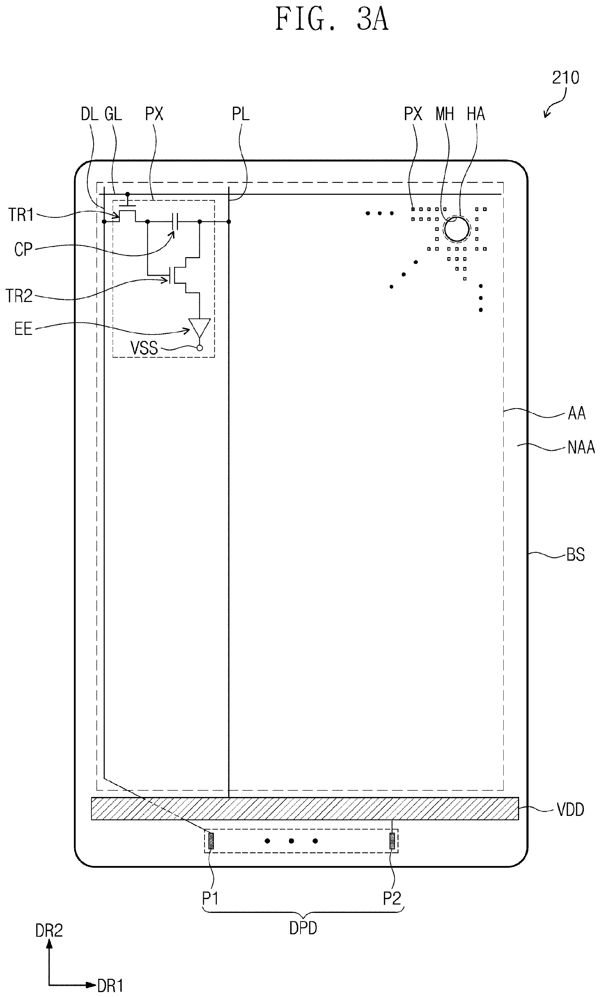

In the display device EA according to an embodiment of the invention, a drive circuit that provides an electrical signal to the active area AA may be directly mounted on the display panel 200. In such an embodiment, the drive circuit may be mounted in the form of a chip, or may be formed together with pixels PX (refer to FIG. 3A). Accordingly, the area of the circuit board 300 may be reduced, or the circuit board 300 may be omitted. The display device EA according to an embodiment of the invention may include various embodiments and is not limited to any one embodiment.

The electronic module 400 may be disposed under the window 100. The electronic module 400 may overlap the hole MH and the hole area HA when viewed from above the plane (when viewed in a plan view or in the third direction DR3). The electronic module 400 may receive an external input transferred through the hole area HA, or may provide an output through the hole area HA.

A receiving unit of the electronic module 400 that receives an external input or an output unit of the electronic module 400 that provides an output may overlap the hole area HA when viewed from above the plane. All or part of the electronic module 400 may be accommodated in the hole area HA or the hole MH. According to an embodiment of the invention, the electronic module 400 may be disposed to overlap the active area AA, and thus the bezel area BZA may be prevented from being increased.

Referring to FIG. 2, in an embodiment, the display device EA may include the display panel 200, a power supply module PM, a first electronic module EM1, and a second electronic module EM2. The display panel 200, the power supply module PM, the first electronic module EM1, and the second electronic module EM2 may be electrically connected with one another. In FIG. 2, the display unit 210 and the sensing unit 220 among the components of the display panel 200 are illustrated as an example.

The first electronic module EM1 and the second electronic module EM2 include various functional modules for operating the display device EA. The first electronic module EM1 may be directly mounted on a mother board electrically connected with the display panel 200, or may be mounted on a separate board and electrically connected to the mother board through a connector (not illustrated).

The first electronic module EM1 may include a control module CM, a wireless communication module TM, an image input module IIM, a sound input module AIM, a memory MM, and an external interface IF. Some of the modules may not be mounted on the mother board and may be electrically connected to the mother board through the flexible substrate CF.

The control module CM controls overall operation of the display device EA. The control module CM may be a microprocessor. In an embodiment, for example, the control module CM activates or deactivates the display panel 200. The control module CM may control other modules, such as the image input module IIM or the sound input module AIM, based on a touch signal received from the display panel 200.

The wireless communication module TM may transmit/receive wireless signals with another terminal through Bluetooth or Wi-Fi. The wireless communication module TM may transmit/receive sound signals using a general communication line. The wireless communication module TM includes a transmitter TM1 that modulates a signal to be transmitted and transmits the modulated signal and a receiver TM2 that demodulates a received signal.

The image input module IIM processes an image signal to covert the image signal into image data capable of being displayed on the display panel 200. The sound input module AIM receives an external sound signal through a microphone in a voice recording mode or a voice recognition mode and converts the external sound signal into electrical voice data.

The external interface IF serves as an interface connected to an external charger, a wired/wireless data port, a card (e.g., a memory card or a SIM/UIM card) socket, or the like.

The second electronic module EM2 may include a sound output module AOM, a light emitting module LM, a light receiving module LRM, and a camera module CMM. The aforementioned components may be directly mounted on the mother board, may be mounted on a separate board and electrically connected with the display panel 200 through a connector (not illustrated), or may be electrically connected with the first electronic module EM1.

The sound output module AOM converts sound data received from the wireless communication module TM or sound data stored in the memory MM and outputs the converted data to the outside.

The light emitting module LM generates and outputs light. The light emitting module LM may output infrared light. In an embodiment, for example, the light emitting module LM may include an LED element. In an embodiment, for example, the light receiving module LRM may sense infrared light. The light receiving module LRM may be activated when infrared light above a certain level is sensed. The light receiving module LRM may include a CMOS sensor. After infrared light generated by the light emitting module LM is output, the infrared light may be reflected by an external object (e.g., the user's finger or face), and the reflected infrared light may be incident to the light receiving module LRM. The camera module CMM takes an external image.

The electronic module 400 according to an embodiment of the invention may include at least one of the components of the first electronic module EM1 and the second electronic module EM2. In an embodiment, for example, the electronic module 400 may include at least one selected from a camera, a speaker, a light detection sensor, and a heat detection sensor. The electronic module 400 may sense an external object received through the hole area HA, or may provide a sound signal such as voice to the outside through the hole area HA. In an embodiment, the electronic module 400 may include a plurality of components and is not limited to any one embodiment.

The electronic module 400 disposed to overlap the hole area HA may easily recognize an external object through the hole area HA, or an output signal generated by the electronic module 400 may be easily transferred to the outside through the hole area HA. Although not illustrated, the display device EA according to an embodiment of the invention may further include a transparent member disposed between the electronic module 400 and the display panel 200. The transparent member may be an optically clear film such that an external input transferred through the hole MH passes through the transparent member and is transferred to the electronic module 400. The transparent member may be attached to the rear surface of the display panel 200, or may be disposed between the display panel 200 and the electronic module 400 without a separate adhesive layer. The display device EA according to an embodiment of the invention may have various structures and is not limited to any one embodiment.

According to an embodiment of the invention, the electronic module 400 may be assembled to overlap the transmissive area TA when viewed from above the plane. Accordingly, the bezel area BZA may be prevented from being increased due to the accommodation of the electronic module 400, and thus the aesthetics of the display device EA may be improved.

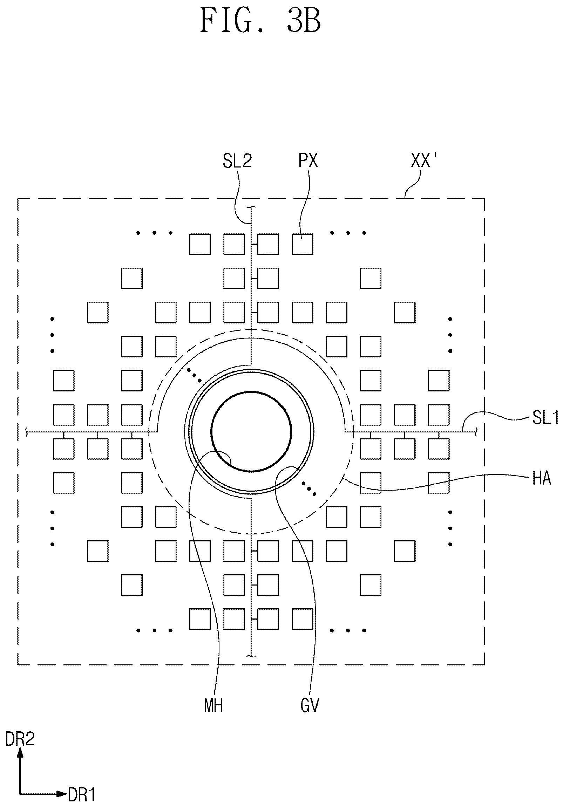

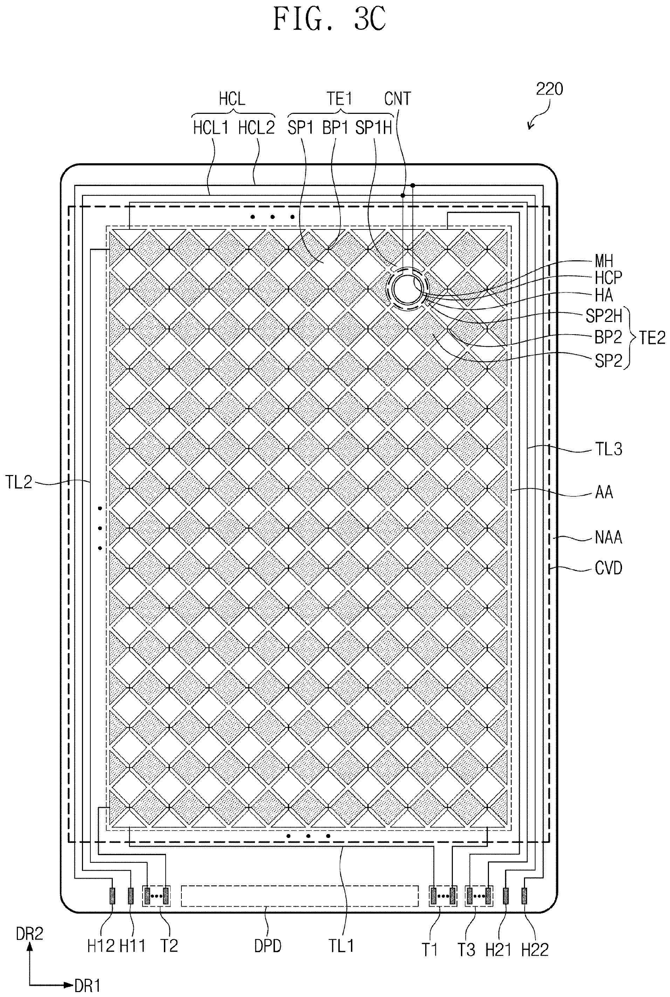

FIG. 3A is a plan view of the display unit according to an embodiment of the invention. FIG. 3B is an enlarged view of a partial area illustrated in FIG. 3A. FIG. 3C is a plan view of the sensing unit according to an embodiment of the invention. FIG. 4 is a sectional view of a partial area of the display panel according to an embodiment of the invention.

FIG. 3A illustrates a schematic signal circuit diagram, and FIG. 3B illustrates an enlarged view of area XX' illustrated in FIG. 1B. In FIGS. 3A to 4, some components are omitted for ease of illustration and description. Hereinafter, embodiments of the invention will be described with reference to FIGS. 3A to 4.

In an embodiment, as illustrated in FIG. 3A, the display unit 210 includes a base substrate BS, a plurality of pixels PX, a plurality of signal lines GL, DL, and PL, and a plurality of display pads DPD.

The active area AA and the peripheral area NAA may be areas provided by the base substrate BS. The base substrate BS may include an insulating substrate. In an embodiment, for example, the base substrate BS may be implemented with a glass substrate, a plastic substrate, or a combination thereof. In an embodiment, the base substrate BS may include the hole area HA, the active area AA adjacent to the hole area HA, and the peripheral area NAA adjacent to the active area AA, which correspond to those of the display panel 200, respectively. The plurality of pixels PX and transistors TR1 and TR2 connected to the plurality of pixels PX may be disposed in the active area AA.

The signal lines GL, DL, and PL are connected to the pixels PX and transfer electrical signals to the pixels PX. Among the signal lines included in the display unit 210, the scan line GL, the data line DL, and the power line PL are illustrated. However, this is illustrative, and the signal lines GL, DL, and PL may further include at least one of a power line, an initialization voltage line, and a light emission control line and are not limited to any one embodiment.

The pixels PX may be disposed in the active area AA. In FIG. 3A, an enlarged signal circuit diagram of one pixel PX among the plurality of pixels PX is illustrated as an example. The pixel PX may include a first thin film transistor TR1, a capacitor CP, a second thin film transistor TR2, and a light emitting element EE. The first thin film transistor TR1 may be a switching element that controls the on/off of the pixel PX. In response to a scan signal transferred through the scan line GL, the first thin film transistor TR1 may transfer or interrupt a data signal transferred through the data line DL.

The capacitor CP may be connected to the first thin film transistor TR1 and the power line PL. The capacitor CP charges an amount of charge corresponding to a difference between a data signal transferred from the first thin film transistor TR1 and a first power signal applied to the power line PL.

The second thin film transistor TR2 may be connected to the first thin film transistor TR1, the capacitor CP, and the light emitting element EE. The second thin film transistor TR2 controls a drive current flowing through the light emitting element EE in correspondence to the amount of charge stored in the capacitor CP. The turn-on time of the second thin film transistor TR2 may be determined based on (or depending on) the amount of charge charged in the capacitor CP. The second thin film transistor TR2 provides the first power signal transferred through the power line PL to the light emitting element EE during the turn-on time.

The light emitting element EE may generate light or control the amount of light depending on an electrical signal. In an embodiment, for example, the light emitting element EE may include an organic light emitting element, a quantum-dot light emitting element, an electrophoretic element, or an electrowetting element.

The light emitting element EE is connected with a power terminal VSS and receives a power signal (hereinafter, referred to as the second power signal) that is different from the first power signal provided by the power line PL. A drive current corresponding to a difference between an electrical signal provided from the second thin film transistor TR2 and the second power signal may flow through the light emitting element EE, and the light emitting element EE may generate light corresponding to the drive current. This is illustrative, and each of the pixels PX may include electronic elements having various configurations and arrangements and is not limited to any one embodiment.

The pixels PX may be disposed around the hole MH and may surround the hole MH when viewed from above the plane. In FIG. 3B, the hole area HA is illustrated by a dotted line for ease of illustration and description. Area XX' includes the area where the hole MH is defined. Hereinafter, the display unit 210 in the area where the hole MH is disposed will be described with reference to FIG. 3B.

As described above, the hole MH may be defined in the active area AA. Accordingly, at least some of the pixels PX may be disposed adjacent to the hole MH. The at least some of the pixels PX may surround the hole MH.

A groove GV may be defined in the hole area HA. The groove GV is disposed along the periphery of the hole MH when viewed from above the plane. In an embodiment, the groove GV may be in a circular ring shape surrounding the hole MH as shown in FIG. 3A. However, this is illustrative, and the groove GV may have a shape different from the shape of the hole MH, may have a polygonal shape, an oval shape, or a closed line shape including at least some curves, or may have a shape including a plurality of partially disconnected patterns and is not limited to any one embodiment.

The groove GV corresponds to a portion recessed from the front surface of the display unit 210 and blocks a path along which moisture or oxygen capable of infiltrating through the hole MH is introduced into the pixel PX. Detailed description thereabout will be given below.

A plurality of signal lines connected to the pixels PX may be disposed in the hole area HA. The signal lines may be connected to the pixels PX via the hole area HA. In FIG. 3B, a first signal line SL1 and a second signal line SL2 among the plurality of signal lines connected to the pixels PX are illustrated for ease of illustration and description.

The first signal line SL1 may extend in the first direction DR1. The first signal line SL1 may be connected to pixels in a same row arranged in the first direction DR1 among the pixels PX. The first signal line SL1 will also be described as the scan line GL.

Some of the pixels PX connected to the first signal line SL1 may be disposed on the left side of the hole MH, and the other pixels PX may be disposed on the right side of the hole MH. Accordingly, the pixels PX in the same row that are connected to the first signal line SL1 may be substantially turned on/off by a same gate signal even though some pixels PX around the hole MH are omitted.

The second signal line SL2 may extend in the second direction DR2. The second signal line SL2 may be connected to pixels PX in the same column arranged in the second direction DR2 among the pixels PX. The second signal line SL2 will also be described as the data line DL.

Some of the pixels PX connected to the second signal line SL2 may be disposed on the upper side of the hole MH, and the other pixels PX may be disposed on the lower side of the hole MH. Accordingly, the pixels PX in a same column that are connected to the second signal line SL2 may receive a data signal through a same line even though some pixels PX around the hole MH are omitted.

The display panel 200 according to an embodiment of the invention may further include a connecting pattern disposed in the hole area HA. In such an embodiment, the first signal line SL1 may be severed in an area overlapping the hole area HA. Disconnected portions of the first signal line SL1 may be connected through the connecting pattern. In such an embodiment, the second signal line SL2 may be severed in an area overlapping the hole area HA, and a connecting pattern that connects disconnected portions of the second signal line SL2 may be additionally provided.

Referring back to FIG. 3A, a power pattern VDD may be disposed in the peripheral area NAA. In an embodiment, the power pattern VDD may be connected with a plurality of power lines PL. Accordingly, the display unit 210 may include the power pattern VDD and thus may provide a same first power signal to the plurality of pixels PX.

The display pads DPD may include a first pad P1 and a second pad P2. The first pad P1 may be provided in plural, that is, a plurality of first pads P1 may be provided. The first pads P1 may be connected to the data lines DL, respectively. The second pad P2 may be connected to the power pattern VDD and may be electrically connected with the power line PL. The display unit 210 may provide electrical signals provided from the outside to the pixels PX through the display pads DPD. The display pads DPD may further include pads for receiving other electrical signals, in addition to the first pad P1 and the second pad P2 and are not limited to any one embodiment.

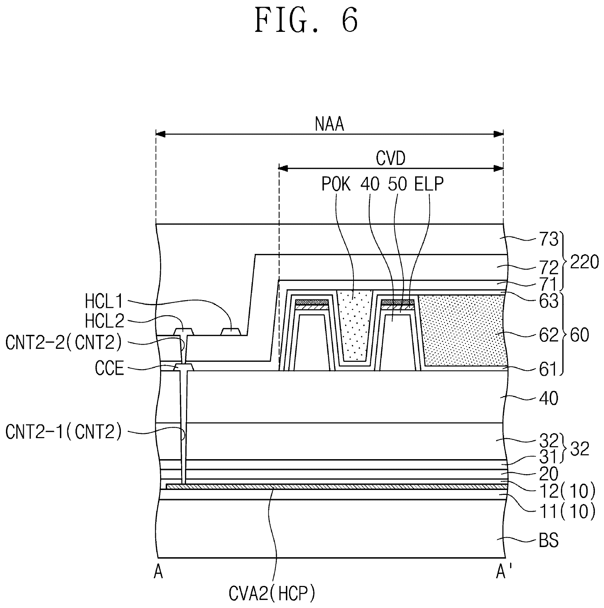

Referring to FIG. 3C, the base substrate BS may further include a cover area CVD that covers the active area AA when viewed from above the plane. Here, the cover area CVD may be an area covered by a first inorganic layer 61 (refer to FIG. 6) and a second inorganic layer 63 (refer to FIG. 6) of an encapsulation layer 60 (refer to FIG. 6). The sensing unit 220 may be disposed on the display unit 210. The sensing unit 220 may sense the external input TC (refer to FIG. 1A) and may obtain information about the location or intensity of the external input TC. The sensing unit 220 includes a plurality of first sensing electrodes TE1, a plurality of second sensing electrodes TE2, a plurality of lines TL1, TL2, and TL3, and a plurality of sensing pads T1, T2, and T3.

The first sensing electrodes TE1 and the second sensing electrodes TE2 may be disposed in an active area AA. The sensing unit 220 may obtain information about the external input TC (refer to FIG. 1A) through a change in capacitance between the first sensing electrodes TE1 and the second sensing electrodes TE2.

The first sensing electrodes TE1 may be arranged in the first direction DR1, and each of the first sensing electrodes TE1 may extend in the second direction DR2. The first sensing electrode TE1 may include a first main pattern SP1, a first adjacent pattern SP1H, and a first connecting pattern BP1.

The first main pattern SP1 may be disposed in the active area AA. The first main pattern SP1 may be spaced apart from the hole MH. The first main pattern SP1 has a certain shape and has a first area. In an embodiment, the first main pattern SP1 may have a rhombus shape. However, this is illustrative, and the first main pattern SP1 may have various shapes and is not limited to any one embodiment.

The first adjacent pattern SP1H may be disposed adjacent to the hole area HA. The first adjacent pattern SP1H has a second area smaller than the first area of the first main pattern SP1. The first adjacent pattern SP1H may have a shape in which an area overlapping the hole area HA is removed from a rhombus shape that is the same as the rhombus shape of the first main pattern SP1.

In an embodiment, the first connecting pattern BP1 may extend in the second direction DR2. The first connecting pattern BP1 may be connected to the first main pattern SP1. The first connecting pattern BP1 may be disposed between two first main patterns SP1 and may connect the two first main patterns SP1. Alternatively, the first connecting pattern BP1 may be disposed between the first main pattern SP1 and the first adjacent pattern SP1H and may connect the first main pattern SP1 and the first adjacent pattern SP1H.

The second sensing electrodes TE2 may be arranged in the second direction DR2, and each of the second sensing electrodes TE2 may extend in the first direction DR1. The second sensing electrode TE2 may include a second main pattern SP2, a second adjacent pattern SP2H, and a second connecting pattern BP2.

The second main pattern SP2 may be spaced apart from the hole MH. The second main pattern SP2 may be spaced apart from the first main pattern SP1. In an embodiment, the spacing between the first main pattern SP1 and the second main pattern SP2 may be spacing on a plane. The first main pattern SP1 and the second main pattern SP2 may transmit and receive different electrical signals, respectively, without making contact with each other.

In an embodiment, the second main pattern SP2 may have the same shape as the first main pattern SP1. In an embodiment, for example, the second main pattern SP2 may have a rhombus shape. However, this is illustrative, and the second main pattern SP2 may have various shapes and is not limited to any one embodiment.

The second adjacent pattern SP2H may be disposed adjacent to the hole MH. The second adjacent pattern SP2H has a smaller area than the second main pattern SP2. The second adjacent pattern SP2H may have a shape in which an area overlapping the hole MH is removed from a rhombus shape that is the same as the rhombus shape of the second main pattern SP2.

In an embodiment, the second connecting pattern BP2 may extend in the first direction DR1. The second connecting pattern BP2 may be connected to the second main pattern SP2. The second connecting pattern BP2 may be disposed between two second main patterns SP2 and may connect the two second main patterns SP2. Alternatively, the second connecting pattern BP2 may be disposed between the second main pattern SP2 and the second adjacent pattern SP2H and may connect the second main pattern SP2 and the second adjacent pattern SP2H.

The sensing lines TL1, TL2, and TL3 may be disposed in a peripheral area NAA. The sensing lines TL1, TL2, and TL3 may include the first sensing lines TL1, the second sensing lines TL2, and the third sensing lines TL3.

The first sensing lines TL1 may be connected to the first sensing electrodes TE1, respectively. In an embodiment, the first sensing lines TL1 may be connected to lower ends of the first sensing electrodes TE1, respectively.

The second sensing lines TL2 may be connected to first ends of the second sensing electrodes TE2, respectively. In an embodiment, the second sensing lines TL2 may be connected to left ends of the second sensing electrodes TE2, respectively.

The third sensing lines TL3 may be connected to upper ends of the first sensing electrodes TE1, respectively. According to an embodiment of the invention, the first sensing electrodes TE1 may be connected to the first sensing lines TL1 and the third sensing lines TL3. Accordingly, the sensitivity depending on areas may be uniformly maintained for the first sensing electrodes TE1 longer than the second sensing electrodes TE2. This is illustrative, and in the sensing unit 220 according to another embodiment of the invention, the third sensing lines TL3 may be omitted, and the invention is not limited to any one embodiment.

The sensing pads T1, T2, and T3 may be disposed in the peripheral area NAA. The sensing pads T1, T2, and T3 may include the first sensing pads T1, the second sensing pads T2, and the third sensing pads T3. The first sensing pads T1 are connected to the first sensing lines TL1, respectively, and provide an external signal to the first sensing electrodes TE1. The second sensing pads T2 and the third sensing pads T3 may be connected to the second sensing lines TL2 and the third sensing lines TL3, respectively, and may be electrically connected with the second sensing electrodes TE2 accordingly.

The sensing unit 220 according to an embodiment of the invention may further include a crack sensing circuit. The crack sensing circuit receives independent electrical signals from the first sensing electrodes TE1 and the second sensing electrodes TE2. The crack sensing circuit may include a crack sensing pattern HCP and a connecting line HCL connected with each other.

The crack sensing pattern HCP may be disposed in the hole area HA. In the hole area HA, the crack sensing pattern HCP may extend along the periphery of the hole area HA. In an embodiment, the crack sensing pattern HCP may have a shape surrounding the periphery of the hole MH.

The crack sensing pattern HCP includes a conductive material. The crack sensing pattern HCP may have conductivity. In an embodiment, the crack sensing pattern HCP may have a one-body shape or integrally formed as a single unitary indivisible part.

The connecting line HCL may be disposed in the peripheral area NAA. In an embodiment, as shown in FIG. 3C, the connecting line HCL may be disposed outward of the first to third sensing lines TL1, TL2, and TL3.

The connecting line HCL may be electrically connected to the crack sensing pattern HCP. The connecting line HCL may include a first connecting line HCL1 and a second connecting line HCL2 spaced apart from each other.

One end of the first connecting line HCL1 may be connected to a first pad H11, and one end of the second connecting line HCL2 may be connected to a second pad H12. In an embodiment, as shown in FIG. 3C, the first pad H11 and the second pad H12 may be disposed on the left side with respect to the area where the display pads DPD are disposed.

An opposite end of the first connecting line HCL1 may be connected to a third pad H21, and an opposite end of the second connecting line HCL2 may be connected to a fourth pad H22. In an embodiment, as shown in FIG. 3C, the third pad H21 and the fourth pad H22 may be disposed on the right side with respect to the area where the display pads DPD are disposed. The first pad H11 and the second pad H12 may be spaced apart from the third pad H21 and the fourth pad H22 with the display pads DPD therebetween.

According to an embodiment of the invention, whether there is a crack in the hole area HA or the peripheral area NAA may be determined through the crack sensing circuit. In the crack sensing circuit, the first pad H11 and the third pad H21 may be input terminals, and the second pad H12 and the fourth pad H22 may be output terminals.

An electrical signal received through the first pad H11 may be transmitted to the crack sensing pattern HCP via the first connecting line HCL1. Thereafter, the electrical signal output from the crack sensing pattern HCP may be output to the second pad H12 via the second connecting line HCL2.

In an embodiment, an electrical signal received through the third pad H21 may be transmitted to the crack sensing pattern HCP via the first connecting line HCL1. Thereafter, the electrical signal output from the crack sensing pattern HCP may be output to the fourth pad H22 via the second connecting line HCL2.

In an embodiment, for example, when the signal sensed from each of the second pad H12 and the fourth pad H22 is detected as a defect such as a level lower than that of a reference signal or a zero (0) level value, there is a high possibility that both the first connecting line HCL1 and the second connecting line HCL2 have been damaged or the crack sensing pattern HCP has been damaged. Accordingly, whether there is a crack in the hole area HA may be determined in this way.

Alternatively, when only the signal sensed from one of the second pad H12 and the fourth pad H22 is not detected as a defect, there is a high possibility that the connecting line HCL has been damaged. Accordingly, whether there is a crack in the peripheral area NAA may be determined in this way. However, this is illustrative. The first pad H11 and the third pad H21 may function as output terminals, and the second pad H12 and the fourth pad H22 may function as input terminals. The invention is not limited to any one embodiment.

Since the sensing unit 220 further includes the crack sensing circuit according to an embodiment of the invention, the sensing unit 220 may easily sense whether there is a defect in the sensing unit 220, particularly, the hole area HA thereof. Accordingly, the reliability of the display device EA may be improved, and whether the display device EA is defective may be determined without a separate inspection circuit or inspection device, which may lead to an increase in process efficiency.

FIG. 4 is a sectional view of a partial area of the display panel according to an embodiment of the invention. Hereinafter, an embodiment of the invention will be described with reference to FIG. 4. The components identical to the components described with reference to FIGS. 1A to 3C will be assigned with the identical reference numerals, and any repetitive detailed descriptions thereof will be omitted.

In an embodiment, as illustrated in FIG. 4, the display unit 210 and the sensing unit 220 may be stacked in the third direction DR3 in the display panel 200. The display unit 210 includes the base substrate BS, the pixel PX (refer to FIG. 3A), a plurality of insulating layers 10, 20, 30, 40, and 50, and the encapsulation layer 60.

In an embodiment, as described above, the base substrate BS may be an insulating substrate. In an embodiment, for example, the base substrate BS may include a plastic substrate or a glass substrate.

In FIG. 4, the transistor TR corresponding to the second thin film transistor TR2 and the light emitting element EE among the components of the equivalent circuit diagram of the pixel PX illustrated in FIG. 3A are illustrated. The insulating layers 10, 20, 30, 40, and 50 may include the first to fifth insulating layers 10, 20, 30, 40, and 50 sequentially stacked one above another. Each of the first to fifth insulating layers 10, 20, 30, 40, and 50 may include an organic material and/or an inorganic material and may have a single-layer structure or a multi-layer structure.

The first insulating layer 10 is disposed on the base substrate BS and covers the front surface of the base substrate BS. The first insulating layer 10 may include a barrier layer 11 and/or a buffer layer 12. Accordingly, the first insulating layer 10 may effectively prevent oxygen or moisture introduced through the base substrate BS from infiltrating into the pixel PX, or may decrease the surface energy of the base substrate BS such that the pixel PX is stably formed on the base substrate BS.

This is illustrative, and in the display panel 200 according to an embodiment of the invention, at least one selected from the barrier layer 11 and the buffer layer 12 may be omitted, or may have a structure in which a plurality of layers are stacked. The invention is not limited to any one embodiment.

A shielding electrode BML may be disposed on the barrier layer 11. When viewed from above the plane, the shielding electrode BML may overlap the transistor TR that will be described below. The shielding electrode BML may be disposed between the transistor TR and the base substrate BS on the cross-section. The shielding electrode BML may block light incident to the transistor TR and a signal line from below the display panel 200 to protect a semiconductor pattern and a conductive pattern of the transistor TR and the signal line. The shielding electrode BML may include a conductive material. In an embodiment, the shielding electrode BML may be connected to the power line PL (refer to FIG. 3A) and may receive a voltage. When the voltage is applied to the shielding electrode BML, the threshold voltage of the transistor TR disposed over the shielding electrode BML may be maintained. Alternatively, without being limited thereto, the shielding electrode BML may be a floating electrode.

The transistor TR may be disposed on the first insulating layer 10. The transistor TR includes a semiconductor pattern SP, a control electrode CE, an input electrode IE, and an output electrode OE. The semiconductor pattern SP may be disposed on the first insulating layer 10. The semiconductor pattern SP may include a semiconductor material. The control electrode CE may be spaced apart from the semiconductor pattern SP with the second insulating layer 20 therebetween. The control electrode CE may be connected with the first thin film transistor TR1 (refer to FIG. 3A) and one electrode of the capacitor CP (refer to FIG. 3A) described above.

The input electrode IE and the output electrode OE may be disposed on the third insulating layer 30 and may be spaced apart from each other when viewed from above the plane. The input electrode IE and the output electrode OE may penetrate the second insulating layer 20 and the third insulating layer 30 and may be connected to one side and an opposite side of the semiconductor pattern SP.

The display unit 210 according to an embodiment of the invention may further include an upper electrode UE. In an embodiment, as shown in FIG. 4, the third insulating layer 30 may include a lower layer 31 and an upper layer 32. However, this is illustrative, and the third insulating layer 30 according to another embodiment of the invention may have a single-layer structure and is not limited to any one embodiment.

The upper electrode UE may be disposed between the lower layer 31 and the upper layer 32. The upper electrode UE may overlap the control electrode CE when viewed from above the plane. In an embodiment, the upper electrode UE may receive an electrical signal that is the same as, or different from, that received by the control electrode CE and may function as one electrode of the capacitor CP. This is illustrative, and in the display panel 200 according to another embodiment of the invention, the upper electrode UE may be omitted, and the invention is not limited to any one embodiment.

The fourth insulating layer 40 is disposed on the third insulating layer 30 and covers the input electrode IE and the output electrode OE. In the transistor TR, the semiconductor pattern SP may be disposed over the control electrode CE. Alternatively, the semiconductor pattern SP may be disposed on the input electrode IE and the output electrode OE. In another embodiment, the input electrode IE and the output electrode OE may be disposed at the same layer as the semiconductor pattern SP and may be directly connected to the semiconductor pattern SP. The transistor TR according to an embodiment of the invention may be formed in various structures and is not limited to any one embodiment.

The light emitting element EE may be disposed on the fourth insulating layer 40. The light emitting element EE includes a first electrode E1, an organic layer EL, and a second electrode E2.

The first electrode E1 may penetrate the fourth insulating layer 40 and may be connected to the transistor TR. Although not illustrated, the display panel 200 may further include a separate connecting electrode disposed between the first electrode E1 and the transistor TR. In such an embodiment, the first electrode E1 may be electrically connected to the transistor TR through the connecting electrode.

The fifth insulating layer 50 may be disposed on the fourth insulating layer 40. The fifth insulating layer 50 may include an organic material and/or an inorganic material and may have a single-layer structure or a multi-layer structure. An opening may be defined in the fifth insulating layer 50. The opening exposes at least a portion of the first electrode E1. The fifth insulating layer 50 may be a pixel defining layer.

The organic layer EL may be disposed between the first electrode E1 and the second electrode E2. The organic layer EL may include at least one light emitting layer. In an embodiment, for example, the organic layer EL may be formed of at least one of materials that emit red light, green light, and blue light and may include a fluorescent material or a phosphorescent material. The organic layer EL may include an organic luminescent material or an inorganic luminescent material. The organic layer EL may emit light in response to a potential difference between the first electrode E1 and the second electrode E2.

In this embodiment, the organic layer EL may be a layer having a one-body shape (or a layer integrally formed as a single unitary and indivisible part) overlapping a plurality of openings. However, this is illustrative, and the organic layer EL may be implemented with a plurality of patterns corresponding to respective openings and is not limited to any one embodiment.

The organic layer EL may further include a charge control layer in addition to the light emitting layer. The charge control layer controls the movement of charge to improve the light emission efficiency and lifetime of the light emitting element EE. The organic layer EL may include at least one selected from a hole transport material, a hole injection material, an electron transport material, and an electron injection material.

The second electrode E2 may be disposed on the organic layer EL. The second electrode E2 may be opposite the first electrodes E1. The second electrode E2 may have a one-body shape extending from the active area AA to the peripheral area NAA (refer to FIG. 3A). The second electrode E2 may be commonly provided for the plurality of pixels PX. The light emitting elements EE, which are disposed in the pixels PX, respectively, receive a common power voltage (hereinafter, referred to as the second power voltage) through the second electrode E2.

The second electrode E2 may include a transmissive conductive material or a transflective conductive material. Accordingly, light generated from the organic layer EL may be easily output in the third direction DR3 through the second electrode E2. However, this is illustrative, and depending on the design, the light emitting element EE according to an embodiment of the invention may be driven by a bottom emission method in which the first electrode E1 includes a transmissive or transflective material or may be driven by a dual emission method in which light is emitted toward both the front surface and the rear surface and is not limited to any one embodiment.

The encapsulation layer 60 is disposed on the light emitting element EE and seals the light emitting element EE. Although not illustrated, a capping layer that covers the second electrode E2 may be additionally disposed between the second electrode E2 and the encapsulation layer 60.

The encapsulation layer 60 may include the first inorganic layer 61, an organic layer 62, and the second inorganic layer 63 sequentially stacked in the third direction DR3. However, without being limited thereto, the encapsulation layer 60 may further include a plurality of inorganic layers and a plurality of organic layers.

The first inorganic layer 61 may cover the second electrode E2. The first inorganic layer 61 may effectively prevent infiltration of external moisture or oxygen into the light emitting element EE. In an embodiment, for example, the first inorganic layer 61 may include silicon nitride, silicon oxide, or a compound obtained by a combination thereof. The first inorganic layer 61 may be formed through a chemical vapor deposition process.

The organic layer 62 may be disposed on the first inorganic layer 61 and may make contact with the first inorganic layer 61. The organic layer 62 may provide a flat surface on the first inorganic layer 61. The organic layer 62 may cover depressions formed on the upper surface of the first inorganic layer 61 or particles existing on the first inorganic layer 61 and may block the surface state of the upper surface of the first inorganic layer 61 from affecting components formed on the organic layer 62. In addition, the organic layer 62 may alleviate stress between layers making contact with each other. The organic layer 62 may include an organic material and may be formed through a solution process such as a spin coating process, a slit coating process, or an ink-jet process.

In an embodiment, the second inorganic layer 63 is disposed on the organic layer 62 and covers the organic layer 62. In such an embodiment, as compared with a case where the second inorganic layer 63 is disposed on the first inorganic layer 61, the second inorganic layer 63 may be stably formed on a relatively flat surface. The second inorganic layer 63 may encapsulate moisture released from the organic layer 62 and may effectively prevent the moisture from being introduced to the outside. The second inorganic layer 63 may include silicon nitride, silicon oxide, or a compound obtained by a combination thereof. The second inorganic layer 63 may be formed through a chemical vapor deposition process.

According to an embodiment, the hole area HA may include the hole MH and the wiring area LA. The wiring area LA may be an area between the hole MH and the active area AA. The wiring area LA may surround the hole MH when viewed from above the plane. The light emitting element EE or the transistor TR disposed in the active area AA may be omitted in the wiring area LA. Accordingly, the hole area HA may have a higher transmittance than the active area AA.

Grooves GV1 and GV2, a dam DMP, and the signal lines SL1 and SL2 of the display unit 210 may be disposed or defined in the wiring area LA.

The grooves GV1 and GV2 may be defined to be spaced apart from each other. The grooves GV1 and GV2 may include the first groove GV1 and the second groove GV2 spaced apart from the active area AA and sequentially formed in a direction toward the hole MH. Each of the first groove GV1 and the second groove GV2 may have a closed line shape surrounding the hole MH or an intermittent line shape surrounding at least a portion of the periphery of the hole MH when viewed from above the plane and is not limited to any one embodiment.

Each of the grooves GV1 and GV2 may be formed by removing at least a portion of the second insulating layer 20 and at least a portion of the third insulating layer 30. A deposition pattern ELP may be disposed in each of the grooves GV1 and GV2 and may be covered by at least one of the first inorganic layer 61 and the second inorganic layer 63.

The display panel 200 according to the invention may include the grooves GV1 and GV2 to sever the continuity between the deposition pattern ELP and the light emitting element EE. Accordingly, the penetration path of external moisture or oxygen may be blocked, and thus damage to elements disposed in the active area AA may be effectively prevented.

In addition, the deposition pattern ELP may be disposed in each of the grooves GV1 and GV2 and may be covered by the first inorganic layer 61 or the second inorganic layer 63 and thus may be effectively prevented from affecting other elements in the manufacturing process of the display panel 200. Accordingly, the process reliability of the display panel 200 may be improved. This is illustrative, and in the display panel 200 according to an embodiment of the invention, the grooves GV1 and GV2 may be singly provided or omitted and are not limited to any one embodiment.

The dam DMP is disposed in the wiring area LA and restricts the formation area of the organic layer 62 to a certain area or less to effectively prevent additional expansion. A plurality of dams DMP may be disposed between the grooves GV1 and GV2. In an embodiment, as shown in FIG. 4, the dam DMP may have a stacked structure including first to third layers P11, P12, and P13. However, this is illustrative, and the dam DMP may have a single-layer structure and is not limited to any one embodiment.

The display panel 200 according to an embodiment of the invention may further include a planarization layer POK. The planarization layer POK includes an organic material. The planarization layer POK may be disposed in the hole area HA. The planarization layer POK covers an uneven surface defined in the hole area HA by the dam DMP or the grooves GV1 and GV2 and provides a flat upper surface. Accordingly, a flat surface may be stably provided even in a region of the hole area HA where the organic layer 62 is not disposed.

The sensing unit 220 may include a plurality of conductive patterns BP and SP and a plurality of sensing insulation layers 71, 72, and 73. The sensing insulation layers 71, 72, and 73 may cover the plurality of conductive patterns BP and SP. The sensing insulation layers 71, 72, and 73 include the first to third sensing insulation layers 71, 72, and 73 sequentially stacked in the third direction DR3.

The first sensing insulation layer 71 may cover the planarization layer POK. In an embodiment, the first sensing insulation layer 71 may cover the upper surface of the planarization layer POK in the hole area HA and may cover the upper surface of the second inorganic layer 63 in the active area AA. The conductive patterns BP and SP may be disposed on the first sensing insulation layer 71.

The second sensing insulation layer 72 and the third sensing insulation layer 73 may have a one-body shape that overlaps the hole area HA and the active area AA.

Each of the first to third sensing insulation layers 71, 72, and 73 may include an inorganic film and/or an organic film. In an embodiment, each of the first to third sensing insulation layers 71, 72, and 73 may be a single layer in an embodiment as shown in FIG. 4. In another embodiment, each of the first to third sensing insulation layers 71, 72, and 73 may have a stacked structure including a plurality of layers making contact with one another and is not limited to any one embodiment.

The conductive patterns HCP, BP, and SP may include the crack sensing pattern HCP, the connecting pattern BP, and the sensing pattern SP. At least a part of the conductive patterns HCP, BP, and SP may constitute or define one of the crack sensing circuit and the sensing electrodes TE1 and TE2 (refer to FIG. 3C) described above.

The sensing pattern SP may be disposed in the active area AA. In an embodiment, the sensing pattern SP may constitute one of the first main pattern SP1 (refer to FIG. 3C), the first adjacent pattern SP1H (refer to FIG. 3C), the second main pattern SP2 (refer to FIG. 3C), and the second adjacent pattern SP2H (refer to FIG. 3C).

The connecting pattern BP may be disposed in the active area AA. The connecting pattern BP may be disposed between the first sensing insulation layer 71 and the second sensing insulation layer 72. The connecting pattern BP may be disposed at (or directly on) a layer different from the layer at which the sensing pattern SP is disposed (or on which the sensing pattern SP is disposed directly).

In an embodiment, the connecting pattern BP may be one of the first connecting pattern BP1 (refer to FIG. 3C) and the second connecting pattern BP2 (refer to FIG. 3C). In an embodiment, as shown in FIG. 4, the sensing pattern SP may be connected to the connecting pattern BP and connected to another adjacent sensing pattern.

In an embodiment, most of the first sensing electrodes TE1 (refer to FIG. 3C) and the second sensing electrodes TE2 (refer to FIG. 3C) are disposed between the second sensing insulation layer 72 and the third sensing insulation layer 73, and only one of the first connecting pattern BP1 and the second connecting pattern BP2 is disposed at a different layer to connect adjacent sensing patterns to each other. However, this is illustrative, and the first sensing electrodes TE1 and the second sensing electrodes TE2 may be disposed at different layers and are not limited to any one embodiment.

The crack sensing pattern HCP may be disposed on the base substrate BS and may be disposed to overlap the hole area HA. The crack sensing pattern HCP may be spaced apart from the sensing pattern SP. Accordingly, the crack sensing pattern HCP may receive an electrical signal independently of the sensing pattern SP and may be operated independently of the sensing pattern SP.

According to an embodiment of the invention, the crack sensing pattern HCP may be disposed in the hole area HA and may sense whether there is a crack in the hole area HA. The crack sensing pattern HCP may be disposed at the same layer as the shielding electrode BML. The crack sensing pattern HCP may be disposed adjacent to the rear surface of the display panel 200. Accordingly, the crack sensing pattern HCP may sense the occurrence or non-occurrence of a crack caused by stress applied from below the base substrate BS. In an embodiment, for example, where the crack sensing pattern HCP is disposed at a same layer as the shielding electrode BML, the crack sensing pattern HCP may better sense whether there is a crack in the rear surface of the display panel 200 than a case where the crack sensing pattern HCP is disposed at a same layer as the sensing pattern SP. Since stress is often applied to the rear surface of the display panel 200 to attach a module material thereto, it may be desired to better sense a crack in the rear direction.

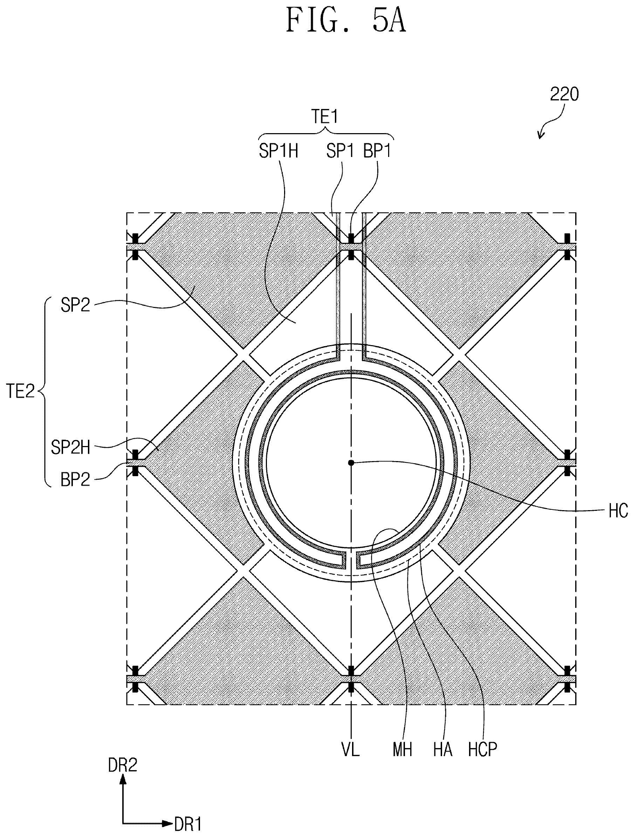

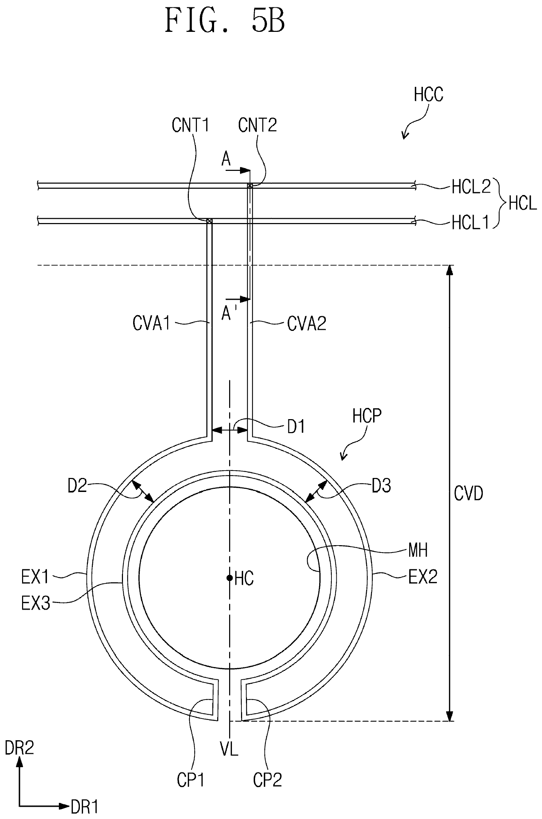

FIG. 5A is a plan view illustrating a portion of the display panel according to an embodiment of the invention. FIG. 5B is a schematic plan view illustrating the crack sensing circuit. Hereinafter, the invention will be described with reference to FIGS. 5A and 5B. The components identical to the components described with reference to FIGS. 1A to 4 will be assigned with the identical reference numerals, and any repetitive detailed descriptions thereof will be omitted.

In FIG. 5A, a partial area of the sensing unit 220 that includes the hole area HA is illustrated. The partial area of the sensing unit 220 may correspond to area XX' in FIG. 1B. In an embodiment, as illustrated in FIG. 5A, the first adjacent patterns SP1H and the second adjacent patterns SP2H may be disposed along the periphery of the hole area HA.

Each of the first adjacent patterns SP1H may be connected with the first main pattern SP1 through the first connecting pattern BP1. Each of the second adjacent patterns SP2H may be connected with the second main pattern SP2 through the second connecting pattern BP2.

The crack sensing pattern HCP of the crack sensing circuit HCC is disposed in the hole area HA and has a shape extending along the periphery of the hole area HA. The crack sensing pattern HCP has a one-body shape (that is, a single unitary indivisible body). The crack sensing pattern HCP may have a shape extending along the periphery of the hole MH when viewed from above the plane. The crack sensing pattern HCP has an open curve shape including opposite ends separated from each other when viewed from above the plane.

The shape of the crack sensing pattern HCP according to an embodiment may have line symmetry with respect to an imaginary line VL. The imaginary line VL may be a line passing through the center HC of the hole area HA. The shape of the crack sensing pattern HCP has bilateral symmetry with respect to the imaginary line VL. Accordingly, the imaginary line VL may be the axis of symmetry of the crack sensing pattern HCP. The sensing pattern HCP may have a semicircular and/or a circular shape, wherein in particular two rows are disposed in parallel to define extending portions.

Referring to FIG. 5B, the crack sensing pattern HCP may include a first extending portion EX1, a second extending portion EX2, a third extending portion EX3, a first connecting portion CP1, a second connecting portion CP2, a first protruding portion CVA1, and a second protruding portion CVA2. The first extending portion EX1, the second extending portion EX2, the third extending portion EX3, the first connecting portion CP1, the second connecting portion CP2, the first protruding portion CVA1, and the second protruding portion CVA2 may be connected with one another to form a one-body shape.

The first extending portion EX1 and the second extending portion EX2 may face each other with respect to the imaginary line VL. IN other words, the first extending portion EX1 and the second extending portion EX2 may be mirrored with respect to the imaginary line VL. Each of the first extending portion EX1 and the second extending portion EX2 may be disposed in the hole area HA and may extend along the periphery of the hole area HA. The first extending portion EX1 and the second extending portion EX2 may be substantially disposed in the wiring area LA (refer to FIG. 4).

The first extending portion EX1 may be disposed on the left side of the imaginary line VL, and the second extending portion EX2 may be disposed on the right side of the imaginary line VL. The first extending portion EX1 may have a semicircular shape that is convex to the left, and the second extending portion EX2 may have a semicircular shape that is convex to the right. The first extending portion EX1 and the second extending portion EX2 may have line symmetry with respect to the imaginary line VL.

The third extending portion EX3 may be spaced apart from the first extending portion EX1 and the second extending portion EX2. The third extending portion EX3 may be disposed closer to the center HC of the hole area HA than the first extending portion EX1 and the second extending portion EX2. The third extending portion EX3 may be parallel to the first extending portion EX1 and the second extending portion EX2.

The third extending portion EX3 may be disposed in the hole area HA and may extend along the periphery of the hole area HA. The third extending portion EX3 may overlap the imaginary line VL when viewed from above the plane. The third extending portion EX3 may cross the imaginary line VL.

The first connecting portion CP1 connects one end of the first extending portion EX1 and one end of the third extending portion EX3. The second connecting portion CP2 is spaced apart from the first connecting portion CP1 and connects one end of the second extending portion EX2 and an opposite end of the third extending portion EX3.

The first connecting portion CP1 and the second connecting portion CP2 may face each other with the imaginary line VL therebetween. Each of the first connecting portion CP1 and the second connecting portion CP2 may extend in a direction parallel to the extension direction of the imaginary line VL. In an embodiment, each of the first connecting portion CP1 and the second connecting portion CP2 may be parallel to the imaginary line VL. The first connecting portion CP1 and the second connecting portion CP2 may have line symmetry with respect to the imaginary line VL.

The first protruding portion CVA1 may be connected to an opposite end of the first extending portion EX1, and the second protruding portion CVA2 may be connected to an opposite end of the second extending portion EX2. The first protruding portion CVA1 and the second protruding portion CVA2 may have line symmetry with respect to the imaginary line VL.

The first protruding portion CVA1 may be connected to the first connecting line HCL1 by a first contact hole CNT1. The second protruding portion CVA2 may be connected to the second connecting line HCL2 by a second contact hole CNT2. Here, the first protruding portion CVA1 and the second protruding portion CVA2 may be connected to different connecting lines. The first contact hole CNT1 and the second contact hole CNT2, when viewed from above the plane, may not overlap the cover area CVD and may overlap the peripheral area NAA (refer to FIG. 3C). Since the first contact hole CNT1 and the second contact hole CNT2 do not overlap the cover area CVD, the encapsulation layer 60 (refer to FIG. 6) may be effectively prevented from being damaged due to the formation of contact holes, and the pixels PX (refer to FIG. 3A) may be effectively prevented from being contaminated by external contaminants.

The first connecting line HCL1 may be connected to one end of the crack sensing pattern HCP and may overlap the peripheral area NAA (refer to FIG. 3C). The second connecting line HCL2 may be connected to an opposite end of the crack sensing pattern HCP and may overlap the peripheral area NAA (refer to FIG. 3C). An input signal received from one end of the first connecting line HCL1 may enter the crack sensing pattern HCP through the first protruding portion CVA1 and may move along the first extending portion EX1, the first connecting portion CP1, the third extending portion EX3, the second connecting portion CP2, and the second extending portion EX2. Thereafter, the input signal may be output from the crack sensing pattern HCP through the second protruding portion CVA2 and may be output to one end of the second connecting line HCL2.

An input signal received from an opposite end of the second connecting line HCL2 may be transmitted to the crack sensing pattern HCP through the second protruding portion CVA2 and may be further transmitted along the second extending portion EX2, the second connecting portion CP2, the third extending portion EX3, the first connecting portion CP1, and the first extending portion EX1. Thereafter, the input signal may be output from the crack sensing pattern HCP through the first protruding portion CVA1 and may be output to an opposite end of the first connecting line HCL1.

Whether the crack sensing pattern HCP or the connecting line HCL is damaged may be determined through the signal output through the one end of the second connecting line HCL2 and the signal output through the opposite end of the first connecting line HCL1. Accordingly, whether there is a crack in the hole area HA or the peripheral area NAA may be easily sensed, and thus the reliability of the display panel may be improved.

While a crack detection signal is provided to the crack sensing pattern HCP, currents may flow in opposite directions between the first extending portion EX1 and the third extending portion EX3 adjacent to each other, between the second extending portion EX2 and the third extending portion EX3 adjacent to each other, and between the first connecting portion CP1 and the second connecting portion CP2 adjacent to each other. In an embodiment, for example, when an input signal is provided through the first connecting line HCL1, a current flows through the first extending portion EX1 and the second extending portion EX2 in the counterclockwise direction with respect to the center HC of the hole area HA, but flows through the third extending portion EX3 in the clockwise direction. In addition, the current flows through the first connecting portion CP1 in the upper direction parallel to the second direction DR2, but flows through the second connecting portion CP2 in the lower direction opposite to the second direction DR2.

Accordingly, parasitic capacitance may be increased as the separation distance D1 between the first protruding portion CVA1 and the second protruding portion CVA2 adjacent to each other, the separation distance D2 between the first extending portion EX1 and the third extending portion EX3 adjacent to each other, and the separation distance D3 between the second extending portion EX2 and the third extending portion EX3 adjacent to each other are decreased. As the separation distance D1 between the first protruding portion CVA1 and the second protruding portion CVA2 is increased, electrical interference between input/output signals may be effectively prevented, and thus electrical reliability may be improved.

In an embodiment, the separation distance D2 between the first extending portion EX1 and the third extending portion EX3 and the separation distance D3 between the second extending portion EX2 and the third extending portion EX3 may be designed to be equal to each other such that parasitic capacitances generated on the left and right sides with respect to the imaginary line VL are allowed to be equal to each other.

According to an embodiment of the invention, the shape of the crack sensing pattern HCP has line symmetry with respect to the imaginary line VL. Accordingly, when the first protruding portion CVA1 serves as an input terminal or when the second protruding portion CVA2 serves as an input terminal, the resistance in the crack sensing pattern HCP may be equally divided from side to side with respect to the imaginary line VL. Thus, the occurrence of static electricity in the crack sensing pattern HCP may be reduced such that damage to the crack sensing pattern HCP may be effectively prevented, which may lead to an improvement in the reliability of the display panel.

According to an embodiment of the invention, the crack sensing circuit HCC may include the crack sensing pattern HCP having line symmetry with respect to the imaginary line VL. The imaginary line VL may pass through the center HC of the hole area HA and may pass between the first protruding portion CVA1 and the second protruding portion CVA2 that function as input/output terminals of the crack sensing pattern HCP.

Accordingly, in an embodiment, whether there is a crack in the display panel may be easily examined without separate equipment. In such an embodiment, the occurrence of static electricity in the crack sensing pattern HCP may be reduced, and thus electrical reliability may be improved.

FIG. 6 is a sectional view taken along line A-A' in FIG. 5B. Hereinafter, the components described with reference to FIGS. 1A to 5B will be assigned with the identical reference numerals, and any repetitive detailed descriptions thereof will be omitted. Furthermore, although FIG. 6 illustrates the connecting structure of the second connecting line HCL2 and the second protruding portion CVA2 in an embodiment, this may be identically applied to the connecting structure of the first connecting line HCL1 and the first protruding portion CVA1 of FIG. 5B.

Referring to FIG. 6, in an embodiment, the second connecting line HCL2 may be connected to the second protruding portion CVA2 through the second contact hole CNT2. The second protruding portion CVA2 may be disposed on the barrier layer 11. That is, the second protruding portion CVA2, which is a portion of the crack sensing pattern HCP, may be disposed at a same layer as the shielding electrode BML (refer to FIG. 4) and may be formed through a same process as the shielding electrode BML (refer to FIG. 4). The second contact hole CNT2 may penetrate (or be defined through) some of the sensing insulation layers 71, 72, and 73 and the insulating layers 40, 30, 20, and 10.

The first connecting line HCL1 and the second connecting line HCL2 may be disposed on the second sensing insulation layer 72. The first connecting line HCL1 and the second connecting line HCL2 may be spaced apart from each other. The first connecting line HCL1 and the second connecting line HCL2 may be disposed at the same layer as the sensing pattern SP (refer to FIG. 4) and may be formed through the same process as the sensing pattern SP (refer to FIG. 4). However, without being limited thereto, the first connecting line HCL1 and the second connecting line HCL2 may have various arrangements. In an embodiment, for example, the first connecting line HCL1 and the second connecting line HCL2 may be disposed on the first sensing insulation layer 71. The first connecting line HCL1 and the second connecting line HCL2 may be disposed at a same layer as the connecting pattern BP (refer to FIG. 4) and may be formed through a same process as the connecting pattern BP (refer to FIG. 4). Alternatively, the first connecting line HCL1 and the second connecting line HCL2 may have a double-layer structure in which one of the first connecting line HCL1 and the second connecting line HCL2 is disposed at a same layer as the sensing pattern SP (refer to FIG. 4), the other of the first connecting line HCL1 and the second connecting line HCL2 is disposed on the connecting pattern BP (refer to FIG. 4), and the first connecting line HCL1 and the second connecting line HCL2 are connected with each other through a contact hole.

The second connecting line HCL2 may be connected with the second protruding portion CVA2 through a connecting electrode CCE. The second connecting line HCL2 may be connected to the connecting electrode CCE by a second-second contact hole CNT2-2 penetrating (or defined through) some of the plurality of sensing insulation layers 71, 72, and 73. The connecting electrode CCE may be connected to the second protruding portion CVA2 by a second-first contact hole CNT2-1 penetrating (or defined through) some of the plurality of insulating layers 40, 30, 20, and 10. In an embodiment, as described above, the second connecting line HCL2 and the second protruding portion CVA2 may be connected through the connecting electrode CCE existing between the second connecting line HCL2 and the second protruding portion CVA2.

The second contact hole CNT2 may not overlap the cover area CVD, and thus the encapsulation layer 60 may be effectively prevented from being damaged due to the formation of a contact hole in the encapsulation layer 60.

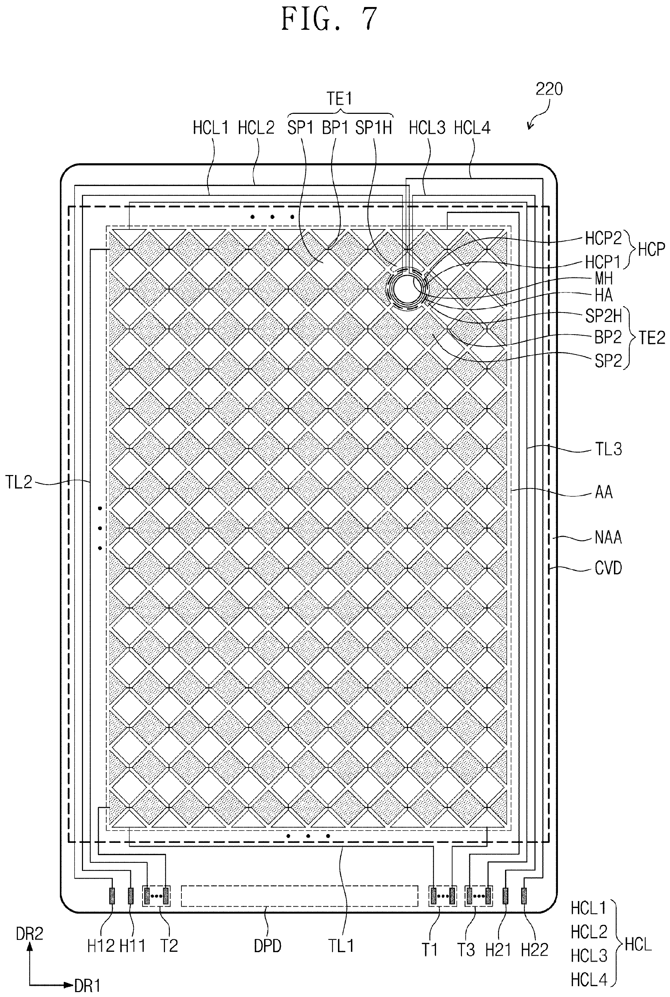

FIG. 7 is a plan view of the sensing unit according to an embodiment of the invention. Hereinafter, components identical to the components described with reference to FIGS. 1 to 6 will be assigned with the identical reference numerals, and any repetitive detailed descriptions thereof will be omitted.

Referring to FIG. 7, in an embodiment, the crack sensing pattern HCP may include a first crack sensing pattern HCP1 and a second crack sensing pattern HCP2 that are disposed on the base substrate BS and that overlap the hole area HA. The first crack sensing pattern HCP1 may be connected with the first connecting line HCL1 and the second connecting line HCL2. The second crack sensing pattern HCP2 may be connected with the third connecting line HCL3 and the fourth connecting line HCL4. The first connecting line HCL1 may be connected with the first pad H11. The second connecting line HCL2 may be connected with the second pad H12. The third connecting line HCL3 may be connected with the third pad H21. The fourth connecting line HCL4 may be connected with the fourth pad H22.

The first to fourth connecting lines HCL1, HCL2, HCL3, and HCL4 may all overlap the peripheral area NAA. All of the first to fourth connecting lines HCL1, HCL2, HCL3, and HCL4 may not overlap the cover area CVD when viewed from above the plane. The first crack sensing pattern HCP1 and the second crack sensing pattern HCP2 may overlap each other when viewed from above the plane. The first crack sensing pattern HCP1 and the second crack sensing pattern HCP2 may overlap the hole area HA when viewed from above the plane.

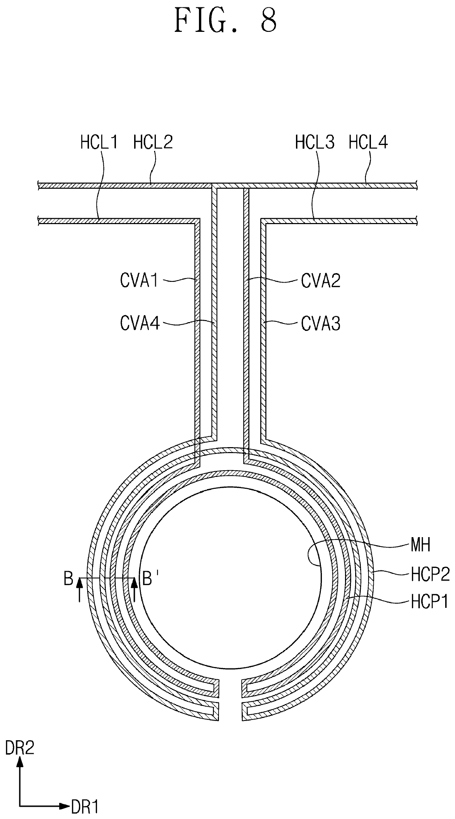

FIG. 8 is a schematic plan view illustrating a crack sensing circuit according to an embodiment of the invention.

Referring to FIG. 8, in an embodiment, the first crack sensing pattern HCP1 and the second crack sensing pattern HCP2 may overlap the hole area HA when viewed from above the plane. The first crack sensing pattern HCP1 and the second crack sensing pattern HCP2 may overlap each other when viewed from above the plane. The first crack sensing pattern HCP1 and the second crack sensing pattern HCP2 may be disposed at (or directly on) different layers, respectively. The first crack sensing pattern HCP1 and the second crack sensing pattern HCP2 may have a same shape as the crack sensing pattern HCP described with reference to FIG. 5B.

One end of the first crack sensing pattern HCP1 may be connected with the first connecting line HCL1 through the first protruding portion CVA1, and an opposite end of the first crack sensing pattern HCP1 may be connected with the second connecting line HCL2 through the second protruding portion CVA2. All of the first crack sensing pattern HCP1, the first protruding portion CVA1, the second protruding portion CVA2, the first connecting line HCL1, and the second connecting line HCL2 may be disposed at a same layer and may be formed in a same process. The first protruding portion CVA1 and the second protruding portion CVA2 may be parallel to each other.

One end of the second crack sensing pattern HCP2 may be connected with the third connecting line HCL3, and an opposite end of the second crack sensing pattern HCP2 may be connected with the fourth connecting line HCL4. All of the second crack sensing pattern HCP2, the third protruding portion CVA3, the fourth protruding portion CVA4, the third connecting line HCL3, and the fourth connecting line HCL4 may be disposed at a same layer and may be formed in a same process. The first protruding portion CVA1, the second protruding portion CVA2, the third protruding portion CVA3 and the fourth protruding portion CVA4 may be parallel to each other. The second protruding portion CVA2 may be located between the third protruding portion CVA3 and the fourth protruding portion CVA4. The fourth protruding portion CVA4 may be located between the first protruding portion CVA1and the second protruding portion CVA2.

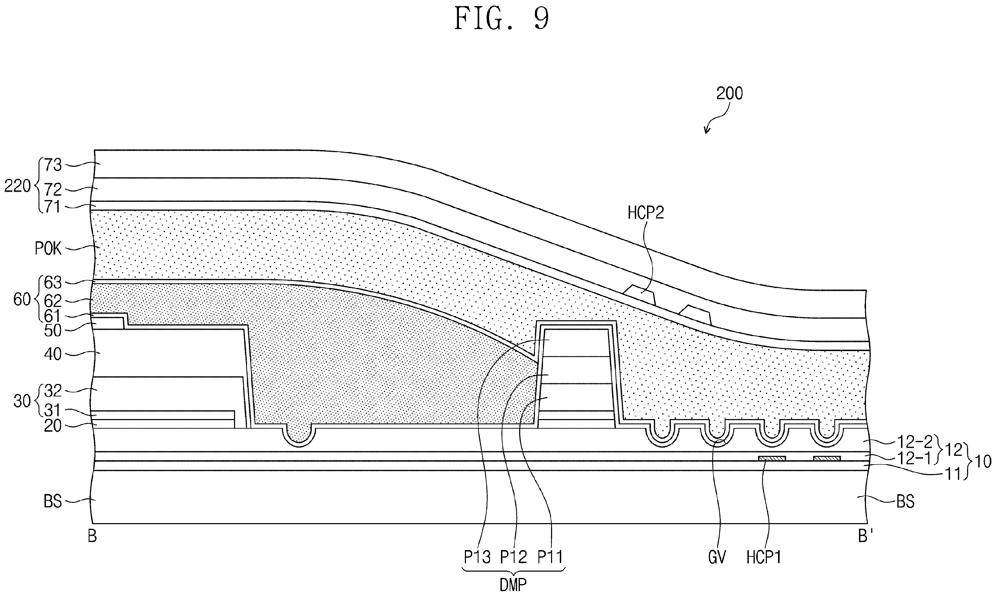

FIG. 9 is a sectional view taken along line B-B' in FIG. 8. Hereinafter, components identical to the components described with reference to FIGS. 1 to 8 will be assigned with the identical reference numerals, and any repetitive detailed descriptions thereof will be omitted.

Referring to FIG. 9, in an embodiment, the dam DMP may effectively prevent the organic layer 62 from flowing into the hole area HA (refer to FIG. 8). The buffer layer 12 may include a first buffer layer 12-1 and a second buffer layer 12-2. A plurality of grooves GV recessed toward the rear surface of the display panel 200 may be formed on the upper surface of the buffer layer 12. The first crack sensing pattern HCP1 may be disposed on the barrier layer 11. The first crack sensing pattern HCP1 may be disposed at a same layer as the shielding electrode BML (refer to FIG. 4) and may be formed through a same process as the shielding electrode BML.

The second crack sensing pattern HCP2 may be disposed on the first sensing insulation layer 71. The second crack sensing pattern HCP2 may be disposed at a same layer as the connecting pattern BP (refer to FIG. 4) and may be formed through a same process as the connecting pattern BP. The second crack sensing pattern HCP2 may be disposed at a same layer as at least one of the plurality of conductive patterns BP and SP (refer to FIG. 4) and may be formed through a same process as the at least one of the plurality of conductive patterns BP and SP (refer to FIG. 4). In an embodiment, for example, unlike that illustrated in FIG. 9, the second crack sensing pattern HCP2 may be disposed on the second sensing insulation layer 72. The second crack sensing pattern HCP2 may be disposed at the same layer as the sensing pattern SP (refer to FIG. 4) and may be formed through the same process as the sensing pattern SP (refer to FIG. 4). Alternatively, the second crack sensing pattern HCP2 may have a double-layer structure in which one portion is disposed on the first sensing insulation layer 71, the remaining portion is disposed on the second sensing insulation layer 72, and the one portion and the remaining portion are connected with each other through a contact hole.

The first crack sensing pattern HCP1 may be disposed adjacent to the rear surface of the display panel 200 and may detect a crack adjacent to the rear surface of the display panel 200. The second crack sensing pattern HCP2 may be disposed adjacent to the front surface of the display panel 200 and may detect a crack adjacent to the front surface of the display panel 200.

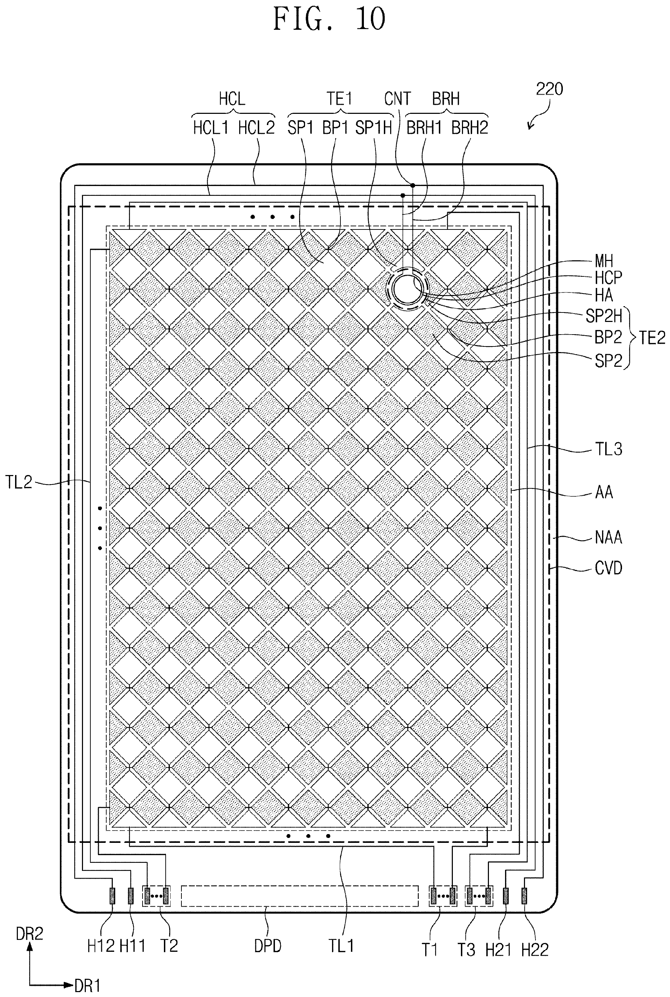

FIG. 10 is a plan view of the sensing unit according to an embodiment of the invention. Hereinafter, components identical to the components described with reference to FIG. 3C will be assigned with the identical reference numerals, and any repetitive detailed descriptions thereof will be omitted.

Referring to FIG. 10, in an embodiment, the crack sensing pattern HCP may be connected to the connecting line HCL by a bridge line BRH. The bridge line BRH may include a first bridge line BRH1 and a second bridge line BRH2. The first bridge line BRH1 may be disposed between the crack sensing pattern HCP and the first connecting line HCL1 and may connect the crack sensing pattern HCP and the first connecting line HCL1. The second bridge line BRH2 may be disposed between the crack sensing pattern HCP and the second connecting line HCL2 and may connect the crack sensing pattern HCP and the second connecting line HCL2. The bridge line BRH may be connected with the first connecting line HCL1 and the second connecting line HCL2 by a contact hole CNT.

The first connecting line HCL1 and the second connecting line HCL2 may be disposed at the same layer as the crack sensing pattern HCP. The bridge line BRH may be disposed at a layer different from the layer at which the crack sensing pattern HCP is disposed.

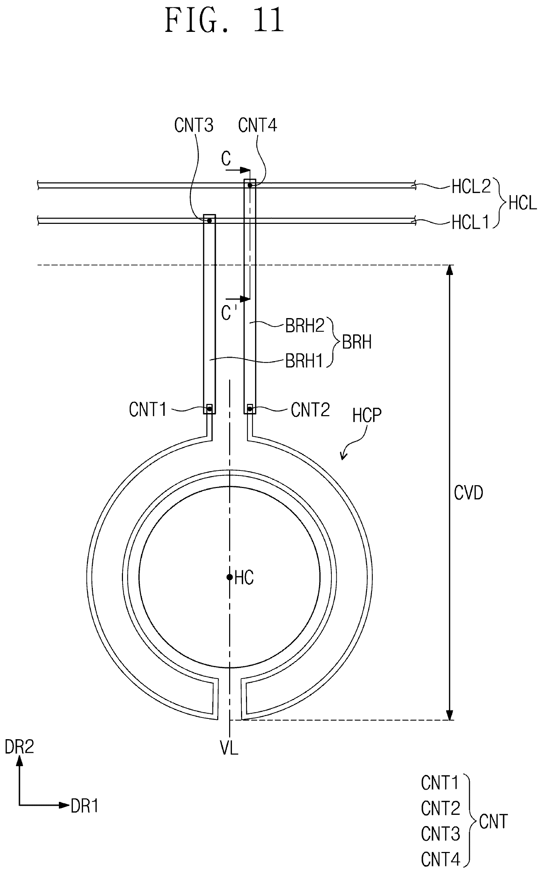

FIG. 11 is a schematic plan view illustrating a crack sensing circuit according to an embodiment of the invention.

Referring to FIG. 11, in an embodiment, the first bridge line BRH1 may be disposed between the first connecting line HCL1 and the crack sensing pattern HCP. The second bridge line BRH2 may be disposed between the second connecting line HCL2 and the crack sensing pattern HCP. One end of the first bridge line BRH1 may be connected to one end of the crack sensing pattern HCP by a first contact hole CNT1. An opposite end of the first bridge line BRH1 may be connected to the first connecting line HCL1 by a third contact hole CNT3. One end of the second bridge line BRH2 may be connected to an opposite end of the crack sensing pattern HCP by a second contact hole CNT2. An opposite end of the second bridge line BRH2 may be connected to the second connecting line HCL2 by a fourth contact hole CNT4.

The first contact hole CNT1 and the second contact hole CNT2 may overlap the hole area HA. The third contact hole CNT3 and the fourth contact hole CNT4 may overlap the peripheral area NAA (refer to FIG. 10) and may not overlap the cover area CVD.

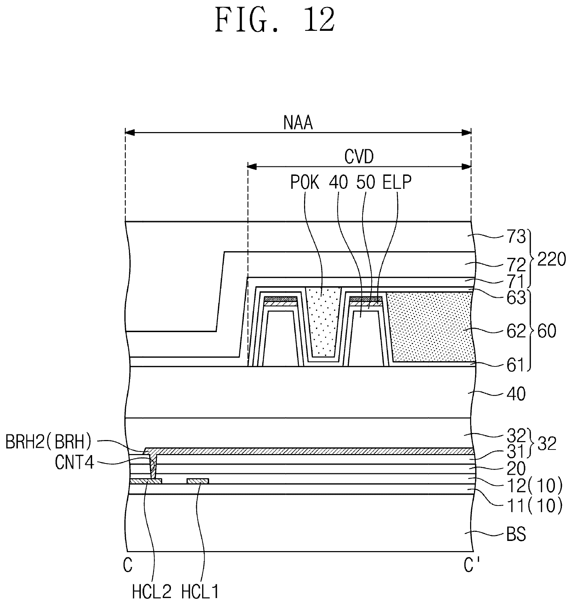

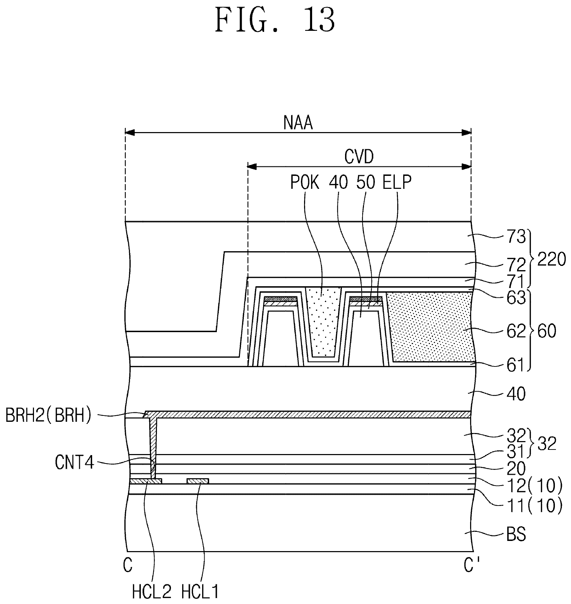

FIGS. 12 and 13 are sectional views taken along line C-C' in FIG. 11 according to an embodiment of the invention. Although the connecting structure of the second bridge line BRH2 and the second connecting line HCL2 in an embodiment will be described with reference to FIGS. 12 and 13, the following description may be identically applied to the connecting structure of the first bridge line BRH1 (refer to FIG. 11) and the first connecting line HCL1 (refer to FIG. 11).

Referring to FIG. 12, in an embodiment, the first connecting line HCL1 and the second connecting line HCL2 may be disposed on the barrier layer 11. The first connecting line HCL1 and the second connecting line HCL2 may be disposed at a same layer as the shielding electrode BML (refer to FIG. 4) and may be formed through a same process as the shielding electrode BML. The first connecting line HCL1 and the second connecting line HCL2 may overlap the peripheral area NAA and may be disposed adjacent to the base substrate BS. Accordingly, the capability to detect a crack adjacent to the rear surface of the peripheral area NAA may be improved.

The second bridge line BRH2 may be disposed on the lower layer 31. The second bridge line BRH2 may be disposed at the same layer as the upper electrode UE (refer to FIG. 4) and may be formed through the same process as the upper electrode UE. The second bridge line BRH2 may be connected with the second connecting line HCL2 by the fourth contact hole CNT4 penetrating (or defined through) the lower layer 31, the second insulating layer 20, and the buffer layer 12.

Referring to FIG. 13, the second bridge line BRH2 may be disposed on the upper layer 32. The second bridge line BRH2 may be disposed at the same layer as the input electrode IE (refer to FIG. 4) and the output electrode OE (refer to FIG. 4) and may be formed through a same process as the input electrode IE (refer to FIG. 4) and the output electrode OE (refer to FIG. 4). The second bridge line BRH2 may be connected with the second connecting line HCL2 by the fourth contact hole CNT4 that penetrates the lower layer 31, the second insulating layer 20, and the buffer layer 12.

In the display device according to an embodiment of the invention, the crack sensing pattern disposed at a same layer as the shielding electrode among the crack sensing patterns may improve the reliability of sensing a crack in the rear surface of the display device. The crack sensing pattern disposed at a same layer as the conductive pattern among the crack sensing patterns may improve the reliability of sensing a crack in the front surface of the display device.

The invention should not be construed as being limited to the embodiments set forth herein. Rather, these embodiments are provided so that this invention will be thorough and complete and will fully convey the concept of the invention to those skilled in the art.

While the invention has been particularly shown and described with reference to embodiments thereof, it will be understood by those of ordinary skill in the art that various changes in form and details may be made therein without departing from the scope of the invention as defined by the following claims.

## Claims

1. An electronic device (EA) comprising a display panel (200),
wherein the display panel (200) comprises:
a base substrate (BS) including a hole area (HA), an active area (AA) adjacent to the hole area (HA), and a peripheral area (NAA) adjacent to the active area (AA), wherein a plurality of pixels (PX) and a transistor (TR) connected to the plurality of pixels (PX) are disposed in the active area (AA);
a shielding electrode (BML) disposed between the transistor (TR) and the base substrate (BS) when viewed in a cross-section;
a first crack sensing pattern (HCP1) disposed on the base substrate (BS) to overlap the hole area (HA);
a first connecting line (HCL1) connected to one end of the first crack sensing pattern (HCP1) and disposed on the base substrate (BS) to overlap the peripheral area (NAA); and
a second connecting line (HCL2) connected to an opposite end of the first crack sensing pattern (HCP1) and disposed on the base substrate (BS) to overlap the peripheral area (NAA),
wherein the first crack sensing pattern (HCP1) is disposed at a same layer as the shielding electrode (BML).

2. The electronic device (EA) of claim 1, further comprising:
a sensing unit (220) disposed over the plurality of pixels (PX), wherein the sensing unit (220) includes a plurality of conductive patterns (BP, SP) and a plurality of sensing insulation layers (71, 72, 73) which covers the plurality of conductive patterns (BP, SP),
wherein the first connecting line (HCL1) and the second connecting line (HCL2) are disposed at a same layer as at least one selected from the plurality of conductive patterns (BP, SP).

3. The electronic device (EA) of claim 1 or 2, further comprising:
a plurality of insulating layers (10, 20, 30 , 40, 50) which covers the transistor (TR),
wherein the first crack sensing pattern (HCP1) is connected with the first connecting line (HCL1) and the second connecting line (HCL2) by a contact hole defined through at least one selected from the plurality of insulating layers (10, 20, 30, 40, 50) and the plurality of sensing insulation layers (71, 72, 73).

4. The electronic device (EA) of claim 3, wherein the base substrate (BS) further includes a cover area (CVD) which covers the active area (AA) when viewed from above a plane, and
wherein the contact hole does not overlap the cover area (CVD) and overlaps the peripheral area (NAA) when viewed from above the plane.

5. The electronic device (EA) of claim 3 or 4, further comprising:
a connecting electrode (CCE) disposed on the plurality of insulating layers (10, 20, 30 , 40, 50) and connected with the first crack sensing pattern (HCP1) by a first contact hole (CNT1) defined through the plurality of insulating layers (10, 20, 30, 40, 50),
wherein the first connecting line (HCL1) and the second connecting line (HCL2) are connected with the first crack sensing pattern (HCP1) by a second contact hole (CNT2) defined through at least one selected from the plurality of sensing insulation layers (71, 72, 73).

6. The electronic device (EA) of at least one of claims 1 or 3 to 5, wherein the first connecting line (HCL1) and the second connecting line (HCL2) are disposed at a same layer as the first crack sensing pattern (HCP1).

7. The electronic device (EA) of at least one of claims 1 or 3 to 6, further comprising:
a second crack sensing pattern (HCP2) disposed on the base substrate (BS) to overlap the hole area (HA);
a third connecting line (HCL3) connected to one end of the second crack sensing pattern (HCP2) and disposed on the base substrate (BS) to overlap the peripheral area (NAA); and
a fourth connecting line (HCL4) connected to an opposite end of the second crack sensing pattern (HCP2) and disposed on the base substrate (BS) to overlap the peripheral area (NAA),
wherein the second crack sensing pattern (HCP2), the third connecting line (HCL3), and the fourth connecting line (HCL4) are disposed at a same layer as each other, and
wherein the second crack sensing pattern (HCP2) is disposed at a layer different from a layer at which the first crack sensing pattern (HCP1) is disposed.

8. The electronic device (EA) of claim 6 or 7, further comprising:
a sensing unit (220) disposed over the plurality of pixels (PX), wherein the sensing unit (220) includes a plurality of conductive patterns (BP, SP) and a plurality of sensing insulation layers (71, 72, 73) which covers the plurality of conductive patterns (BP, SP),
wherein the second crack sensing pattern (HCP2) is disposed at a same layer as at least one selected from the plurality of conductive patterns (BP, SP).

9. The electronic device (EA) of claim 1, further comprising:
a first bridge line (BRH1) disposed between the first crack sensing pattern (HCP1) and the first connecting line (HCL1) and connected to the first crack sensing pattern (HCP1) and the first connecting line (HCL1); and
a second bridge line (BRH2) disposed between the first crack sensing pattern (HCP1) and the second connecting line (HCL2) and connected to the first crack sensing pattern (HCP1) and the second connecting line (HCL2).

10. The electronic device (EA) of claim 9, wherein the first connecting line (HCL1) and the second connecting line (HCL2) are disposed at a same layer as the first crack sensing pattern (HCP1).

11. The electronic device (EA) of claim 9 or 10, further comprising:
a plurality of insulating layers (10, 20, 30, 40, 50) which covers a pixel circuit including the transistor (TR),
wherein the pixel circuit further includes a semiconductor pattern (SP) and an upper electrode (UE) disposed over the semiconductor pattern (SP) to overlap the semiconductor pattern (SP), and
wherein the first bridge line (BRH1) and the second bridge line (BRH2) are disposed at a same layer as the upper electrode (UE).

12. The electronic device (EA) of claim 11, further comprising:
an input electrode (IE) and an output electrode (OE) disposed on one insulating layer among the plurality of insulating layers (10, 20, 30 , 40, 50) and connected with the semiconductor pattern (SP) by a through-hole defined through at least one selected from the plurality of insulating layers (10, 20, 30 , 40, 50),
wherein the first bridge line (BRH1) and the second bridge line (BRH2) are disposed at a same layer as the input electrode (IE) and the output electrode (OE).

13. The electronic device (EA) of claim 9, further comprising:
a plurality of insulating layers (10, 20, 30 , 40, 50) which covers the transistor (TR),
wherein the first bridge line (BRH1) and the second bridge line (BRH2) are connected with the first crack sensing pattern (HCP1) by a third contact hole (CNT3) defined through at least one selected from the plurality of insulating layers (10, 20, 30, 40, 50) and are connected with the first connecting line (HCL1) and the second connecting line (HCL2) by a fourth contact hole (CNT4) defined through at least one selected from the plurality of insulating layers (10, 20, 30 , 40, 50).

14. The electronic device (EA) of claim 13, wherein the third contact hole (CNT3) overlaps the hole area (HA), and
wherein the fourth contact hole (CNT4) overlaps the peripheral area (NAA).

15. The electronic device (EA) of at least one of claims 1 to 14, further comprising:
a window (100) disposed on the display panel (200); and
an electronic module (400) disposed to overlap the hole area (HA).
